# EUROPEAN PATENT APPLICATION

(11) **EP 1 081 997 A1**
(43) Date of publication of application: **07.03.2001**
(21) Application number: 00307576.9
(22) Date of filing: 01.09.2000
(51) Int. Cl.: H05K 13/02

(54) **Method and apparatus for supplying electric components**

(30) Priority: 02.09.1999 JP 24884399
(71) Applicant: Fuji Machine Mfg. Co., Ltd., Chiryu-shi, Aichi-ken (JP)
(72) Inventor: Suhara, Shinsuke, Yama-machi, Chiryu-shi, Aichi-ken (JP); Ito, Toshiya, Yama-machi, Chiryu-shi, Aichi-ken, (JP); Kawai, Takayoshi, Yama-machi, Chiryu-shi, Aichi-ken (JP)
(74) Representative: Moir, Michael Christopher

(57) **Abstract**

A method of supplying electric components from component-supply tables each of which includes component feeders whose respective component-supply portions are arranged along a line and each of which stores electric components of one sort and supplies the components, one by one, from the component-supply portion thereof, the method including the steps of moving a first one of the tables along the line in a component-supply area so as to position each of the respective component-supply portions of the feeders of the first table, at a component-supply position, keeping a second one of the tables still in one of two waiting areas provided on both sides of the component-supply area, placing, when one of the feeders of the second table kept still in the one waiting area is unable to supply any electric components, the one feeder in a state in which the one feeder is able to supply electric components, moving, at a terminal stage of a component-supply period in which the first table supplies the components, a third one of the tables is to supply electric components after the first table, such that the third table is moved near, and with, the first table, and replacing, with the third table, the first table which includes one feeder unable to supply any electric components, so that the third table supplies the components in place of the first table, while deferring the supplying of electric component from at least the one feeder of the first table.

## Description

### BACKGROUND OF INVENTION

### Field of Invention

The present invention relates to a method and an apparatus for supplying electric components, for example of different sorts, from a plurality of movable component-supply tables to an object, such as an electric-component mounting device.

### Related Art Statement

The above-indicated electric-component ("EC") supplying method and apparatus are needed, for example, when a plurality of electric components ("ECs") are mounted on a printed-wiring board to produce an electric-circuit board. An example of the EC supplying apparatus is disclosed in Japanese Patent Document No. 8-21793. The disclosed EC supplying apparatus includes a plurality of component-supply tables each of which includes (a) a movable table which is movable in an intermediate, component-supply area and two waiting areas, respectively provided on both sides of the component-supply area and (b) a plurality of EC feeders which are provided on the movable table such that respective component-supply portions of the feeders are arranged in a direction in which the table is moved and each of which stores ECs of one sort and supplies the ECs, one by one, from the component-supply portion thereof.

In the case where one of the component-supply tables can supply all ECs needed to produce an electric-circuit board, the one table is moved in the component-supply area to position sequentially each of the respective component-supply portions of the component feeders of the one table, at a predetermined component-supply position, and supply at least one EC from the each component-supply portion positioned at the component-supply position. The other component-supply table or tables is or are kept in the waiting areas. Conventionally, it has been practiced that in the waiting areas an operator replenishes ECs to one or more EC feeders on the waiting table(s) and/or replaces one or more EC feeders on the waiting table(s) with one or more new EC feeders. On the other hand, in the case where the plurality of component-supply tables cooperate with each other to supply all ECs needed to produce an electric-circuit board, it is usually practiced to move concurrently the component-supply tables in the component-supply area. When at least one of the EC feeders of the component-supply tables has become unable to supply any ECs, for example, because the one EC feeder has supplied all ECs stored therein and therefore has no ECs, or because a disorder or a jamming has occurred to an EC feeding device thereof, it is practiced to interrupt temporarily the current EC supplying operation and perform an operation needed to place the one EC feeder in a state in which the one EC feeder can supply ECs. Likewise, in the case where the plurality of component-supply tables are alternately moved to the component-supply area to supply ECs, when at least one of the EC feeders of the component-supply tables has become unable to supply any ECs, it is practiced to interrupt temporarily the current EC supplying operation and perform an operation needed to place the one EC feeder in a state in which the one EC feeder can supply ECs. However, while the EC supplying operation is interrupted, no ECs are mounted on the printed-wiring board. Thus, the rate of operation of an EC mounting system which includes the EC supplying apparatus and the EC mounting device and which is considerably expensive, and the rate of operation of a circuit-board assembly line including the EC mounting system are lowered. This problem occurs to not only the EC mounting system but also an EC supplying apparatus which sequentially supplies ECs of different sorts for achieving a different purpose.

### SUMMARY OF INVENTION

It is therefore an object of the present invention to provide an electric-component supplying method and an electric-component supplying apparatus each of which uses a plurality of component-supply tables which cooperate with each other to perform an EC supplying operation and each of which can effectively avoid, when at least one of electric-component feeders provided on the component-supply tables has become unable to supply any electric components, the lowering of the efficiency of supplying of electric components.

In a first aspect, the present invention provides a method of supplying electric components from a plurality of component-supply bodies each of which includes a movable body and a plurality of component feeders for storing electric components, the method comprising the steps of:
moving a first supply component-supply body in a component-supply area so as to position component feeders of the component-supply body at component-supply positions for supply of at least one electric component from said feeders;
holding a second component-supply body in a waiting area to enable a component feeder of said second component-supply body to be serviced;
moving a replacement component-supply body into the component-supply area during supply of components from the first component-supply body; and
replacing the first component-supply body in the component-supply area with the replacement component-supply body when at least one of the component feeders of the first component-supply body is unable to supply any electric components so as to continue to supply electric components from the component-supply area without interruption.

The term "service" includes replenishment, repair and/or replacement of a feeder.

According to a first preferred embodiment, there is provided a method of supplying electric components from a plurality of component-supply tables each of which includes a movable table and a plurality of component feeders which are provided on the movable table such that respective component-supply portions of the feeders are arranged along a line and each of which stores electric components of one sort and supplies the electric components, one by one, from the component-supply portion thereof, the method comprising the steps of moving a first one of the component-supply tables along the line in a component-supply area so as to position each of the respective component-supply portions of the component feeders of the first component-supply table, at a component-supply position, and supply at least one electric component from the each component-supply portion positioned at the component-supply position, keeping a second one of the component-supply tables that is different from the first component-supply table, still in one of two waiting areas which are provided on both sides of the component-supply area, respectively, placing, when at least one of the component feeders of the second component-supply table kept still in the one waiting area is unable to supply any electric components, the one component feeder in a state in which the one component feeder is able to supply electric components, moving, at a terminal stage of a component-supply period in which the first component-supply table supplies the electric components from the component feeders thereof, a third one of the component-supply tables that is different from the first component-supply table and is to supply electric components after the first component-supply table, such that the third component-supply table is moved near, and with, the first component-supply table, and replacing the first component-supply table with the third component-supply table, so that the third component-supply table supplies the electric components in place of the first component-supply table, wherein when at least one of the component feeders of the first component-supply table which is supplying the electric components in the component-supply area is unable to supply any electric components, the supplying of at least one electric component from at least the one component feeder of the first component-supply table is deferred and the first component-supply table including the one component feeder is replaced with the third component-supply table.

The third component-supply table may comprise the second component-supply table, and the step of replacing the first component-supply table with the third component-supply table may comprise replacing the first component-supply table with the second component-supply table.

The phrase "one component feeder which is unable to supply any electric components" means, for example, a component feeder which has supplied all electric components ("ECs") and therefore does not have any ECs, or a component feeder which has ECs but cannot feed any ECs because of a disorder or a jamming. The phrase "placing the one component feeder in a state in which the one component feeder is able to supply electric components" means, for example, that the one component feeder is replenished with new ECs, or that the one component feeder is replaced with a new component feeder which has new ECs. In the case where the one component feeder cannot supply any ECs because of disorder or jamming, the one component feeder can be placed in the state in which the one component feeder is able to supply electric components, by eliminating the disorder or jamming, if the disorder or jamming is easy to eliminate. In this case, usually, the one component feeder can be placed in that state by being replaced with a normal one.

The phrase "moving ... a third one of the component-supply tables that ... is to supply electric components after the first component-supply table, such that the third component-supply table is moved near, and with, the first component-supply table, and replacing, with the third component-supply table, the first component-supply table" means changing a first state in which the first component-supply table supplies the ECs, to a second state in which the third component-supply table supplies the ECs. This change may be done such that after the first component-supply table has completed the supplying of ECs, the third component-supply table starts the supplying of ECs, or such that once the third component-supply table starts the supplying of ECs, the first component-supply table supplies at least one EC and then the third component-supply table resumes the supplying of ECs, that is, the above first state is changed to the above second state via an intermediate state in which the first and second tables alternately supply the ECs.

The present EC supplying method generally relates to a method in which a plurality of component-supply tables cooperate with each other to supply ECs, but particularly to such a method in which the time when only one component-supply table supplies the ECs in the component-supply area is maximized and the other component-supply table or tables is or are kept still in the waiting area or areas, so that an operator may replace, on the table kept still in the waiting area, a component feeder with a new one, or may replenish a component feeder with new ECs. Therefore, the present method need not interrupt the EC supplying operation for performing the feeder replacing operation or the EC replenishing operation, which leads to improving the efficiency of supplying of ECs. This is stark contrast to the previously-indicated conventional EC supplying methods. In addition, two component-supply tables are replaced with each other in such a manner that while one component-supply table is moved near, and with, the other component-supply table, the other component-supply table is replaced with the one component-supply table. That is, two component-supply tables can be replaced with each other without having to interrupt the EC supplying operation. This feature also contributes to improving the efficiency of supplying of ECs.

When two component-supply tables are simultaneously moved to be replaced with each other, a greater vibration is produced than that produced when only one component-supply table is moved. To avoid this problem, it is preferred to move simultaneously the two component-supply tables at an acceleration and a deceleration which are smaller than those at which only one component-supply table is moved.

Preferably, the step of moving the first component-supply table in the component-supply area comprises finding, from the component feeders of the first component-supply table which is supplying the electric components in the component-supply area, the at least one component feeder which is unable to supply any electric components, and deferring the supplying of at least one electric component from at least the one component feeder of the first component-supply table, the step of replacing the first component-supply table comprises replacing the first component-supply table including the one component feeder, with the third component-supply table, moving the first component-supply table including the one component feeder, from the component-supply area into one of the two waiting areas, keeping the first component-supply table still in the one waiting area, and placing the one component feeder of the first component-supply table in a state in which the one component feeder is able to supply electric components, and the method further comprises a step of moving the first component-supply table into the component-supply area so as to perform the deferred supplying of at least one electric component from at least the one component feeder of the first component-supply table.

One of the two waiting areas into which the first component-supply table including the one component feeder is moved from the component-supply area may be the same, or different from, one of the two waiting areas in which the second component-supply table is kept still.

If one of the component feeders of one component-supply table has become unable to supply any ECs, it is possible to defer, in a first manner, the supplying of ECs from not only the one feeder but also all subsequent feeders that are to supply ECs subsequent to the one feeder. However, it is preferred to defer, in a second manner, the supplying of ECs from only the one feeder, or only the one feeder and at least one special subsequent feeder which has an essential need to supply an EC subsequent to the one feeder and to supply ECs from the remaining feeders. For example, when one component-supply table performs an EC supplying operation to supply ECs to one printed-wiring board and thereby produce one electric-circuit board, two or more of the component feeders provided on the one table may become unable to supply any ECs. If the above first manner is applied to this case, it is needed to replace the two component-supply tables with each other two or more times; but if the second manner is employed, it is needed to replace, only one time, the two component-supply tables with each other. In addition, if the second manner is employed, the two tables are replaced with each other after almost all the component feeders provided on the one table, except for the two or more feeders in question, supply the ECs. This leads to increasing and stabilizing a time interval at which one table is replaced with another, thereby enabling the operator to perform stably his or her operation on the component-supply table kept still in the waiting area. In contrast, if the first manner is employed, the time interval at which one table is replaced with another is not stable, which may cause the operator not to complete his or her operation on the table kept still in the waiting area. In this case, the operator must interrupt his or her operation, to allow the replacement of two tables with each other, or must interrupt the current EC supplying operation to complete his or her operation. This results in increasing the possibility that the operator may not perform his or her operation or that the efficiency of supplying of ECs may be lowered.

Preferably, the third component-supply table comprises the second component-supply table, the step of moving the first component-supply table in the component-supply area comprises moving the first component-supply table to supply, for being mounted on a printed-wiring board, the electric components prior to the second component-supply table, and finding, from the component feeders of the first component-supply table, the one component feeder which is unable to supply any electric components, and deferring the supplying of at least one electric component from at least the one component feeder of the first component-supply table, the step of replacing the first component-supply table with the third component-supply table comprises replacing the first component-supply table including the one component feeder, with the second component-supply table, moving, while the second component-supply table supplies, for being mounted on the printed-wiring board, the electric components in the component-supply area, the first component-supply table including the one component feeder, from the component-supply area into one of the two waiting areas, keeping the first component-supply table still in the one waiting area, and placing the one component feeder of the first component-supply table in the state in which the one component feeder is able to supply electric components, and the step of moving the first component-supply table into the component-supply area comprises moving, after the second component-supply table finishes supplying the electric components for being mounted on the printed-wiring board, the first component-supply table into the component-supply area so as to replace the second component-supply table with the first component-supply table and perform, for the printed-wiring board, the deferred supplying of at least one electric component from at least the one component feeder of the first component-supply table.

The present EC supplying method relates to a method in which two component-supply tables are used to supply ECs to, e.g., an EC mounting device. When one of the component feeders of the first component-supply table has become unable to supply any ECs, the supplying of EC from at least the one component feeder of the first component-supply table is deferred, and the first component-supply table including the one component feeder is replaced with the second component-supply table, so that the second component-supply table supplies the ECs, and the one component feeder of the first component-supply table is placed in the state in which the one component feeder is able to supply ECs. After the second component-supply table finishes supplying the ECs, the first component-supply table replaces the second component-supply table and performs the deferred supplying of EC from at least the one component feeder. Thus, the EC supplying operation for one printed-circuit board is finished. At this time, the first table is present in the component-supply area, and therefore can start an EC supplying operation for another printed-wiring board prior to the second table. Thus, it is needed to replace, only one time, the first and second tables with each other, like in the case where no feeders of the first table become unable to supply any ECs, and it is not needed to replace two printed-wiring boards with each other as described later. Therefore, the efficiency of supplying of ECs is substantially maintained.

Preferably, the third component-supply table comprises the second component-supply table, the step of moving the first component-supply table in the component-supply area comprises moving the first component-supply table to supply, for being mounted on a first printed-wiring board, the electric components subsequent to the second component-supply table, and finding, from the component feeders of the first component-supply table, at least one component feeder which is unable to supply any electric components, and deferring the supplying of at least one electric component from at least the one component feeder of the first component-supply table, the step of replacing the first component-supply table with the third component-supply table comprises replacing the first component-supply table including the one component feeder, with the second component-supply table, conveying the first printed-wiring board which is incomplete, from a component-mount station to a downstream side thereof, conveying a second printed-wiring board to the component-mount station from an upstream side thereof, moving, while the second component-supply table supplies, for being mounted on the second printed-wiring board, the electric components in the component-supply area, the first component-supply table including the one component feeder, from the component-supply area into one of the two waiting areas, keeping the first component-supply table still in the one waiting area, and placing the one component feeder of the first component-supply table in the state in which the one component feeder is able to supply electric components, and the step of moving the first component-supply table into the component-supply area comprises moving, after the second component-supply table finishes supplying the electric components for being mounted on the second printed-wiring board, the first component-supply table into the component-supply area so as to replace the second component-supply table with the first component-supply table, return the second printed-wiring board from the component-mount station to the upstream side thereof, return the first printed-wiring board to the component-mount station from the downstream side thereof, and perform, for the first printed-wiring board, the deferred supplying of at least one electric component from at least the one component feeder of the first component-supply table.

The present EC supplying method may be used for supplying ECs to an EC mounting device. The present method relates to the case where the first table supplies, for being mounted on a first printed-wiring board, the ECs subsequent to the second table, and the component feeders of the first table is found to include a component feeder which is unable to supply any ECs. According to this method, it is needed to convey the first and second printed-wiring boards forward and backward, one more time, as compared with the case where no feeders of the first table become unable to supply any ECs. Therefore, the efficiency of supplying of ECs is lowered to some extent, but that extent is much lower than that to which the efficiency is lowered by interrupting the EC supplying operation to place the component feeder which is unable to supply any ECs, in the state in which the feeder can supply ECs.

Preferably, the third component-supply table is different from the second component-supply table, the step of moving the first component-supply table in the component-supply area comprises moving the first component-supply table to supply, for being mounted on a printed-wiring board, the electric components subsequent to the second component-supply table and prior to the third component-supply table, and finding, from the component feeders of the first component-supply table, at least one component feeder which is unable to supply any electric components, and deferring the supplying of at least one electric component from at least the one component feeder of the first component-supply table, the step of replacing the first component-supply table with the third component-supply table comprises replacing the first component-supply table including the one component feeder, with the third component-supply table, moving, while the third component-supply table and at least one possible component-supply table that possibly follows the third component-supply table supply, for being mounted on the printed-wiring board, the electric components in the component-supply area, the first component-supply table including the one component feeder, from the component-supply area into one of the two waiting areas, keeping the first component-supply table still in the one waiting area, and placing the one component feeder of the first component-supply table in the state in which the one component feeder is able to supply electric components, and the step of moving the first component-supply table into the component-supply area comprises moving, after the third component-supply table and the one possible component-supply table finish supplying the electric components for being mounted on the printed-wiring board, the first component-supply table toward the other waiting area via the component-supply area where the first component-supply table performs, for the printed-wiring board, the deferred supplying of at least one electric component from at least the one component feeder of the first component-supply table.

The present EC supplying method may employ one or more first component-supply tables between the second component-supply table as the initial table and the third component-supply table as the last table.

The present EC supplying method relates to the case where three or more component-supply tables cooperate with one another to perform an EC supplying operation, and particularly to the case where the first table supplies the ECs subsequent to the second table and prior to the third table, and the feeders of the first table is found to include a feeder which is unable to supply any ECs. The case where the feeders of the second table as the initial table is found to include a feeder which is unable to supply any ECs can be treated by the method according to the above; and the case where the feeders of the third table as the last table is found to include a feeder which is unable to supply any ECs can be treated by the method according to the above. If the present method is applied to the above-indicated particular case where the first table supplies the ECs subsequent to the second table and prior to the third table and the feeders of the first table is found to include a feeder unable to supply any ECs, the present method can complete an EC supplying operation in a time substantially equal to the time needed for the three or more tables having no feeders that are unable to supply ECs, to complete an EC supplying operation.

Preferably, the third component-supply table is different from the second component-supply table, the step of moving the first component-supply table in the component-supply area comprises moving the first component-supply table to supply, for being mounted on a printed-wiring board, the electric components prior to the third component-supply table, and finding, from the component feeders of the first component-supply table, at least one component feeder which is unable to supply any electric components, and deferring the supplying of at least one electric component from at least the one component feeder of the first component-supply table, the step of replacing the first component-supply table with the third component-supply table comprises replacing the first component-supply table including the one component feeder, with the third component-supply table, moving, while the third component-supply table supplies, for being mounted on the printed-wiring board, the electric components in the component-supply area, the first component-supply table including the one component feeder, from the component-supply area into one of the two waiting areas, keeping the first component-supply table still in the one waiting area, and placing the one component feeder of the first component-supply table in the state in which the one component feeder is able to supply electric components, and the step of moving the first component-supply table into the component-supply area comprises moving, after the third component-supply table finishes supplying the electric components for being mounted on the printed-wiring board, the first component-supply table into the component-supply area so as to perform, for the printed-wiring board, the deferred supplying of at least one electric component from at least the one component feeder of the first component-supply table.

The present EC supplying method is another method which is applicable to the case where three or more component-supply tables cooperate with one another to perform an EC supplying operation. The case where the feeders of the third table as the last table is found to include a feeder which is unable to supply any ECs can be treated by the above.

However, in the case where three or more component-supply tables are subsequent to one component-supply table having one feeder which is unable to supply an ECs, it is possible to supply first the ECs from two or more (but not all) of the three or more tables and then return the one table to the component-supply area to perform the deferred supplying of EC from the one feeder. The last method is advantageously applied to the case where each component-supply table is relatively small (i.e., the number of feeders provided on each table is relatively small) and each table finishes its EC supplying operation in a relatively short time, because an operator can place, in the waiting area, the one feeder of the one table in the state in which the one feeder can supply the ECs, during a sufficient time needed for the two or more tables to supply the ECs.

Preferably, the step of deferring the supplying of at least one electric component from at least the one component feeder of the first component-supply table comprises deferring the supplying of at least one electric component from only the one component feeder of the first component-supply table.

Preferably, the step of deferring the supplying of at least one electric component from at least the one component feeder of the first component-supply table comprises deferring the supplying of at least one electric component from each of the one component feeder of the first component-supply table and at least one subsequent component feeder of the first component-supply table that is to supply at least one electric component subsequent to the one component feeder.

Preferably, the step of deferring the supplying of at least one electric component from the at least one subsequent component feeder of the first component-supply table comprises deferring, when a plurality of subsequent component feeders of the first component-supply table each of which is to supply at least one electric component subsequent to the one component feeder of the first table comprise at least one special subsequent component feeder which has an essential need to supply at least one electric component subsequent to the one component feeder of the first table, the supplying of at least one electric component from the special subsequent component feeder.

The phrase "essential need to supply at least one electric component subsequent to the one component feeder of the first table" means, for example, a case where prescribed EC-mount places on a printed-wiring board or respective shapes and/or dimensions of ECs make it impossible or difficult to perform the deferred supplying of EC from the one feeder of the first table, if the special subsequent component feeder supplies EC prior to the one component feeder of the first table. The presence or absence of "essential need" can be judged by determining, in advance, a criterion for judging whether each feeder has the essential need and, each time one feeder unable to supply any ECs is found, judging each feeder subsequent to the one feeder has the essential need, according to the criterion. Alternatively, it is possible to find, for each feeder, at least one feeder which must not supply EC subsequent to the each feeder, and prepare, in advance, data indicating the results. In the latter case, one or more special subsequent feeders for each feeder can be found quickly. Generally, small and/or light ECs are mounted prior to large and/or heavy ECs, because, in a particular the case where an EC mounting device mounts, on a printed-wiring board, ECs at a predetermined EC-mount position while the board is moved to position, at the EC-mount position, each prescribed EC-mount place on the board, the board is moved at small acceleration and deceleration after large and/or heavy ECs are mounted on the board. In the last case, it is desirable not to change the order of supplying of ECs from the feeders and to minimize the total number of feeders the supplying of ECs from which is deferred.

In a second aspect, the present invention provides apparatus for supplying electric components to an electric-component mounting device for mounting the electric components on a printed-wiring board positioned at a component-mount station, the apparatus comprising:
a plurality of component-supply bodies each of which includes a movable body and a plurality of component feeders for storing electric components;
a body moving device for moving each of the component-supply bodies in a component-supply area and a waiting area; and
a body-moving-device control device for controlling the body moving device to move a first, supply component-supply body in the component-supply area so as to position component feeders of the component-supply body at component-supply positions for supply of at least one electric component from said feeders, for holding a second component-supply body in a waiting area, for moving a replacement component-supply body into said component-supply area during supply of components from said first component-supply body, and for replacing the first component-supply body in the component-supply area with the replacement component-supply body when at least one of the component feeders of the first component-supply body is unable to supply any electric components so as to continue to supply electric components from the component-supply area without interruption.

According to a second preferred embodiment of the present invention, there is provided an apparatus for supplying electric components to an electric-component mounting device which mounts the electric components on a printed-wiring board positioned at a component-mount station and thereby produces a circuit board, the apparatus comprising a plurality of component-supply tables each of which includes a movable table and a plurality of component feeders which are provided on the movable table such that respective component-supply portions of the feeders are arranged along a line and each of which stores electric components of one sort and supplies the electric components, one by one, from the component-supply portion thereof; a table moving device which moves the each of the component-supply tables along the line in a component-supply area and at least one of two waiting areas which are provided on both sides of the component-supply area, respectively; and a table-moving-device control device which controls the table moving device to move a first one of the component-supply tables along the line in the component-supply area so as to position each of the respective component-supply portions of the component feeders of the first component-supply table, at a component-supply position, and supply at least one electric component from the each component-supply portion positioned at the component-supply position, which keeps a second one of the component-supply tables that is different from the first component-supply table, still in one of the two waiting areas, and which moves, at a terminal stage of a component-supply period in which the first component-supply table supplies the electric components from the component feeders thereof, a third one of the component-supply tables that is different from the first component-supply table and is to supply electric components after the first component-supply table, such that the third component-supply table is moved near, and with, the first component-supply table, and replaces the first component-supply table with the third component-supply table, so that the third component-supply table supplies the electric components in place of the first component-supply table, wherein when at least one of the component feeders of the first component-supply table which is supplying the electric components in the component-supply area is unable to supply any electric components, the table-moving-device control device defers the supplying of at least one electric component from at least the one component feeder of the first component-supply table and replaces the first component-supply table including the one component feeder with the third component-supply table.

In the present EC supplying apparatus, the component-supply table or tables other than the first component-supply feeder which is supplying the ECs in the component-supply area is or are kept still in the waiting area or areas. Therefore, an operator can perform his or her operation, such as replenishing one or more feeders with ECs, or replacing one or more feeders with one or more new ones, on the table or tables kept still in the waiting area or areas. Thus, the present apparatus is advantageously used for carrying out the EC supplying method according to the first aspect.

Preferably, the apparatus further comprises a table-movement inhibiting device which comprises a manually operable member and which inhibits, based on a first manual operation of the manually operable member, the table moving device from moving the second component-supply table from the one waiting area into the component-supply area and allows, based on a second manual operation of the manually operable member, the table moving device to move the second component-supply table from the one waiting area into the component-supply area.

When the operator performs his or her operation, such as replenishing one or more feeders with ECs, or replacing one or more feeders with one or more new ones, on the table or tables kept still in the waiting area or areas, it is desirable for safety purposes that the table-movement inhibiting device be operated to inhibit the table moving device from moving the table or tables from the waiting area or areas into the component-supply area. The manually operable member may be a manually operable button or a manually operable lever. Alternatively, the manually operable member may be a cover member which is closed and opened to cover one or both of the waiting areas. In the last case, the table-movement inhibiting device may be adapted to inhibit the movement of the table or tables when the operator opens the cover member to gain access to the table or tables kept still in the waiting area of areas. This is very advantageous because the operator is prevented from gaining access to the table or tables without operating the manually operable member.

Preferably, the apparatus further comprises a board conveying device which conveys the printed-wiring board to the component-mount station from an upstream side thereof and conveys the printed-wiring board from the component-mount station to a downstream side thereof; and means for controlling the board conveying device to a first printed-wiring board from the component-mount station to the downstream side thereof, convey a second printed-wiring board to the component-mount station from the upstream side thereof, and then return the second printed-wiring board from the component-mount station to the upstream side thereof, and the first printed-wiring board to the component-mount station from the downstream side thereof.

Preferably, the apparatus further comprises means for detecting, from the component feeders of the first component-supply table which is supplying the electric components in the component-supply area, at least one component feeder which is unable to supply any electric components, the table-moving-device control device controls the table moving device to move the first component-supply table in the component-supply area while deferring the supplying of at least one electric component from at least the one component feeder of the first component-supply table and to move the first component-supply table including the one component feeder into one of the two waiting areas; and means for informing an operator of a fact that the first component-supply table including the one component feeder is moved into the one waiting area.

The informing means may be one, such as a buzzer, which produces a sound, or one, such as a lamp or a blinker, which produces a light.

### BRIEF DESCRIPTION OF DRAWINGS

The above and optional objects, features, and advantages of the present invention will be better understood by reading the following detailed description of the preferred embodiments of the invention, when considered in conjunction with the accompanying drawings, in which:
Fig. 1 is a schematic elevation view of an electric-component ("EC") mounting system including an EC supplying apparatus embodying the present invention;
Fig. 2 is a plan view of the EC supplying apparatus and a board conveying device of the EC mounting system;
Fig. 3 is a schematic plan view of the EC mounting system;
Fig. 4 is a diagrammatic view of a relevant portion of a control device of the EC mounting system;
Figs. 5A, 5B, 5C, and 5D are views for explaining respective steps of a normal EC supplying operation performed by the EC supplying apparatus;
Figs. 6A, 6B, 6C, and 6D are views for explaining respective steps of a first special EC supplying operation performed by the EC supplying apparatus;
Figs. 7A, 7B, 7C, 7D, 7E, and 7F are views for explaining respective steps of a second special EC supplying operation performed by the EC supplying apparatus;
Fig. 8 is a schematic elevation view of another EC mounting system including another EC supplying apparatus as a second embodiment of the present invention;
Fig. 9 is a plan view of the EC supplying apparatus of Fig. 8;
Fig. 10 is a diagrammatic view of a relevant portion of a control device of the EC mounting system of Fig. 8;
Fig. 11A is a view showing a state in which the EC supplying apparatus of Fig. 8 starts an EC supplying operation;
Fig. 11B is a view showing a state in which the EC supplying apparatus of Fig. 8 ends the EC supplying operation;
Figs. 12A, 12B, 12C, 12D, and 12E are views for explaining respective steps of a normal EC supplying operation performed by the EC supplying apparatus of Fig. 8;
Figs. 13A, 13B, 13C, 13D, 13E, and 13F are views for explaining respective steps of a first special EC supplying operation performed by the EC supplying apparatus;
Figs. 14A, 14B, 14C, 14D, 14E, and 14F are views for explaining respective steps of a second special EC supplying operation performed by the EC supplying apparatus;
Figs. 15A, 15B, 15C, 15D, 15E, and 15F are views for explaining respective steps of a third special EC supplying operation performed by the EC supplying apparatus; and
Figs. 16A, 16B, 16C, 16D, 16E, and 16F are views for explaining respective steps of a third special EC supplying operation performed by the EC supplying apparatus.

### DETAILED DESCRIPTION OF PREFERRED EMBODIMENTS

Hereinafter, there will be described an electronic-component ("EC") mounting system including an EC supplying apparatus 20 embodying the present invention.

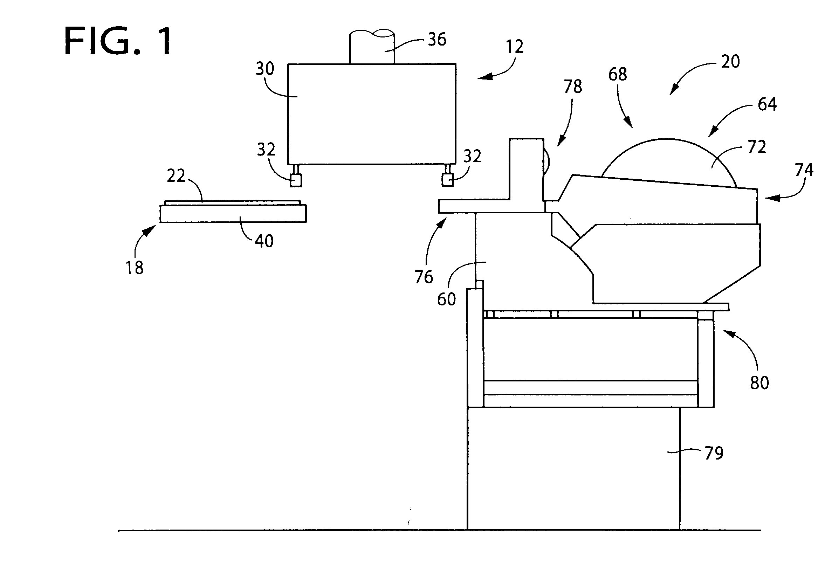

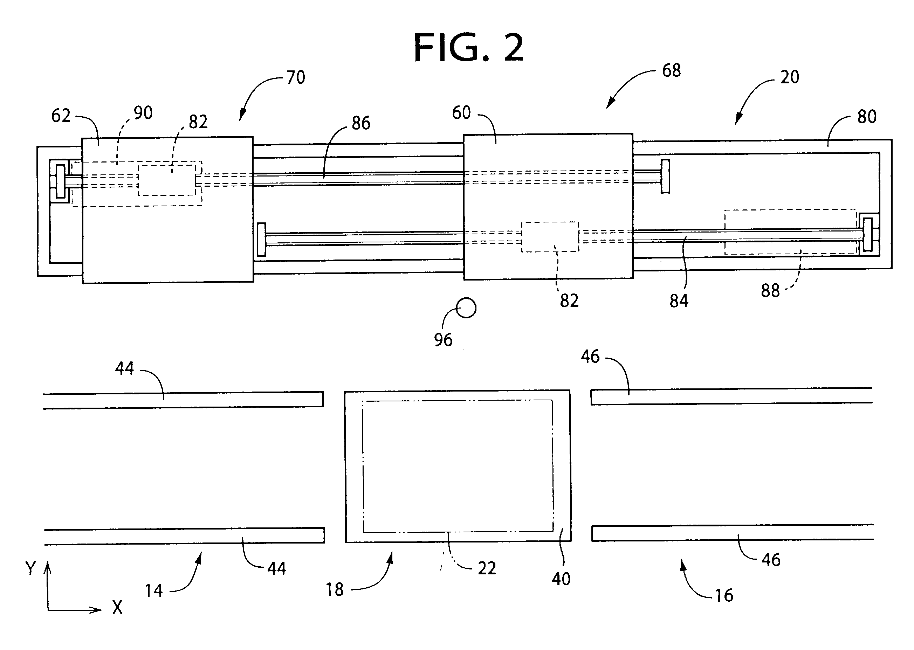

The present EC mounting system includes, as shown in Figs. 1 and 2, an EC mounting device 12, a board carry-in device 14, a board carry-out device 16, and a board positioning and supporting device 18, in addition to the EC supplying apparatus 20. The EC supplying apparatus 20 supplies electronic components ("ECs") each as a sort of electric component, to the EC mounting device 12, which mounts the ECs on a printed-wiring board ("PWB") 22 which is positioned and supported by the board positioning and supporting device 18.

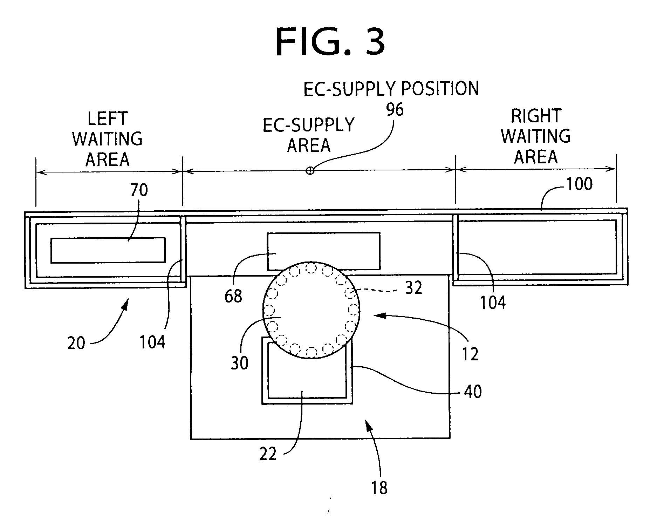

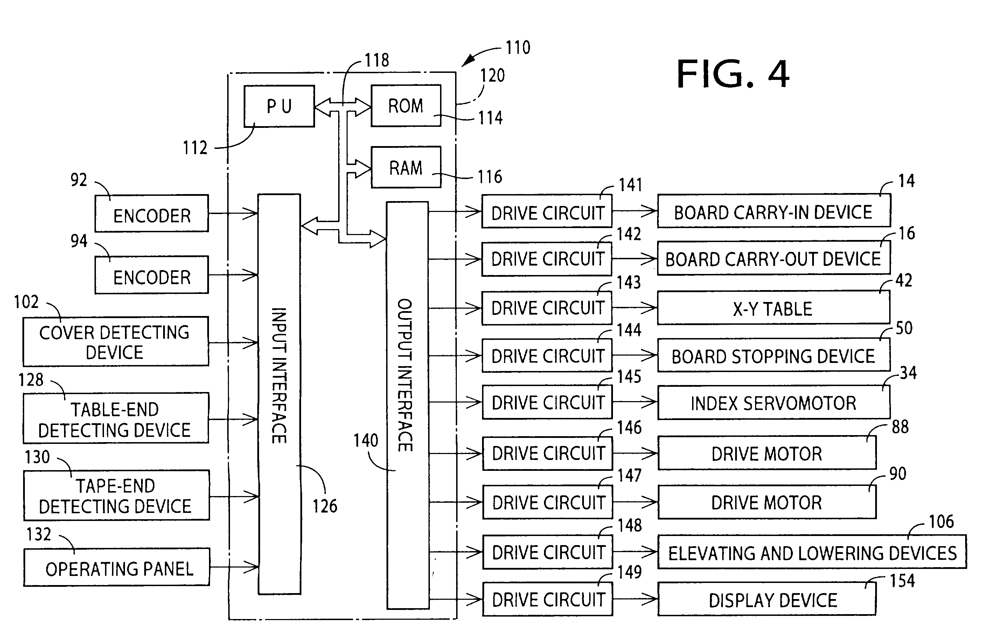

The EC mounting device 12 includes an index table 30 as a rotatable body that is intermittently rotatable about a vertical axis line. The index table 30 supports a plurality of EC suction heads 32 each as an EC holding head. Fig. 3 shows sixteen EC suction heads 32. The index table 30 is intermittently rotated by an intermittently rotating device as a sort of EC-holding-head moving device that includes an index servomotor 34 (Fig. 4). The rotation of the index servomotor 34 is transmitted by a motion transmitting device (not shown) including a cam and a cam follower, a rotary shaft 36 which is fixed to the index table 30, so that the index table 30 is intermittently rotated and each of the sixteen EC suction heads 32 is sequentially moved to an EC-suck position, an EC-position-detect position, an EC-position-correct position, and an EC-mount position. At each of the EC-suck position and the EC-mount position, a head elevating and lowering device (not shown) is provided which elevates and lowers each of the EC suction heads 32 that is being positioned thereat. Each of the two head elevating and lowering devices includes a movable member, and a motion converting device which includes a cam and a cam follower and converts the rotation of the index servomotor 34 into the upward and downward movements of the movable member. Thus, each EC suction head 32 is moved downward and upward at each of the EC-suck position and the EC-mount position.

The board positioning and supporting device 18 is identical with that disclosed in Japanese Patent Publication No. 8-21793, therefore detailed description and illustration thereof is omitted. The positioning and supporting device 18 will be just briefly described, below. The positioning and supporting device 18 includes a board-support table 40 which positions and supports a PWB 22 at an EC-mount station. The board-support table 40 is provided on an X-Y table 42 (Fig. 4) as part of a PWB moving device that is movable in an X-axis direction (i.e., a direction perpendicular to the sheet of Fig. 1) and a Y-axis direction (i.e., a left-right direction in Fig. 1) which is perpendicular to the X-axis direction on a horizontal plane. The board-support table 40 is not horizontally movable relative to the X-Y table 42, and is vertically movable by an elevating and lowering device (not shown). The board- support table 40 is moved, by the elevating and lowering device, between its upper-end position and its lower-end position. While the table 40 is positioned at the upper-end position, the PWB 22 is carried-in onto the table 40, and is carried out from the table 22. While the table 40 is positioned at its lower-end position, the table 40 is moved with the X-Y table 42, so that the PWB 22 is moved to any position on the horizontal plane. On both sides of the board-support table 40 in the X-axis direction, there are provided the board carry-in device 14 including a carry-in conveyor 44 and the board carry-out device 16 including a carry-out conveyor 46, respectively. The carry-in and carry-out devices 14, 16 conveys the PWB 22 in a direction parallel to the X-axis direction, so that the PWB 22 is carried-in onto the board-support table 40 and carried-out from the table 40. First, the PWB 22 which has been conveyed by the carry-in device 14 is placed onto the support table 40. Second, the support table 40 is moved downward to its lower-end position, so that the support table 40 is moved with the X-Y table 42 in the X-axis and Y-axis directions, without being interfered with by the carry-in or carry-out device 14, 16, and each of prescribed EC-mount places on the PWB 22 is moved to a position right below one EC suction head 32 being positioned at the EC-mount position of the index table 30. Thus, the EC held by the one EC suction head 32 is mounted on the PWB 22. When all ECs are mounted on the prescribed EC-mount places on the PWB 22, the PWB 22 is completed as a printed circuit board, and the support table 40 supporting the PWB 22 is moved upward to its upper-end position, so that the PWB 22 is transferred from the support table 40 onto the carry-out device 16, which carries out the PWB 22.

The board positioning and supporting device 18 additionally includes a board stopping device 50 (Fig. 4). The board stopping device 50 may be one which is disclosed in Japanese Patent Publication No. 10-163683 and the corresponding European Patent Application No. 97309568. The board stopping device 50 includes two stopper members which are distant from each other in the X-axis direction as a board-convey direction, and a stopper-member moving device which moves each of the stopper members to its operative position and its inoperative position. At the operative position, each stopper member is projected upward from a board-convey plane on which the PWB 22 is conveyed by the board-support table 40, so that the each stopper member stops the movement of the PWB 22; and at the inoperative position, each stopper member is retracted downward below the board-convey plane, so that the each stopper member allows the passing of the PWB 22. When the movement of the PWB 22 from the upstream side toward the downstream side in the board-convey direction should be stopped, the downstream one of the two stopper members is moved to its operative position, so that the PWB 22 is engaged with the downstream-side stopper member and is stopped thereby. Similarly, when the movement of the PWB 22 from the downstream side toward the upstream side direction should be stopped, the upstream stopper member is moved to its operative position, so that the PWB 22 is engaged with the upstream-side stopper member and is stopped thereby. Thus, the movement of the PWB 22 in the board-convey direction is prevented by the board stopping device 50. In addition, a positioning device (not shown) such as positioning pins which is provided on the X-Y table 42 of the positioning and supporting device 18 and which can engage the PWB 22, accurately positions the PWB 22 on the support table 40. However, the board stopping device may be one which is disclosed in Japanese Patent Publication No. 10-51189 and includes a stopper member which is pivotable to its operative position and its inoperative position.

Next, the EC supplying apparatus 20 will be described.

The EC supplying apparatus 20 includes, as shown in Figs. 1 and 2, a first table 60 and a second table 62. A plurality of EC feeders 64 are detachably attached to each of the two tables 60, 62, such that respective EC-supply portions of the EC feeders 64 are arranged along a straight line parallel to the X-axis direction. Thus, a first EC-supply table 68 and a second EC-supply table 70 are provided. In Fig. 2, the EC feeders 64 are not shown. Each of the EC feeders 64 employed in the present embodiment is identical with that disclosed in Japanese Patent Publication No. 10-34456, and detailed description and illustration thereof are omitted. Fig. 1 schematically illustrates one of the EC feeders 64 each of which includes a reel holder 74 holding an EC-tape reel 72 on which an EC tape is wound; a feeding device 76 which engages feed holes formed through the EC tape and regularly feeds the tape at a predetermined feed pitch equal to a predetermined pocket pitch at which a plurality of EC-accommodating pockets are regularly formed in a carrier tape of the EC tape; and a take-up device 78 which takes up a cover film which is adhered to an upper surface of the carrier tape. Each EC tape carries a plurality of ECs of one sort. The feeding device 76 and the take-up device 78 are driven by a drive device which includes the index servomotor 34 as a drive source thereof.

In the present embodiment, all sorts of ECs that should be mounted on a certain sort of PWB 22 to produce a corresponding sort of circuit board, are divided into two groups which should be supplied from the two EC-supply tables 68, 70, respectively. That is, the two EC-supply tables 68, 70 cooperate with each other to supply the ECs to the EC mounting device 12. The two tables 60, 62 have respective sizes the sum of which can support such a great number of EC feeders 64 that can supply a corresponding great number of sorts of ECs that is greater than the greatest number of sorts of ECs that is usually expected to be mounted on each PWB 22.

Each of the first and second EC-supply tables 68, 70 is movably fitted, via guide blocks (not shown) as guided portions thereof that are fixed to a lower surface thereof, on a rail-like table guide 80 as a guiding device that extends, on a bed 79, parallel to the X-axis direction as the board-convey direction. Each of the two EC-supply tables 68, 70 is guided by the guide table 80, such that the respective EC-supply portions of the EC feeders 64 attached thereto are moved along the straight line parallel to the X-axis direction. As shown in Fig. 2, a nut 82 is fixed to the lower surface of each EC-supply table 60, 62 is threadedly engaged with a corresponding feed screw 84, 86. Each of the two feed screws 84, 86 is fixed to the table guide 80 such that each screw 84, 86 is not movable relative to the guide 80 in a direction parallel to an axis line of the screw 84, 86 and is rotatable relative to the same 80 about the axis line. The two feed screws 84, 86 are rotated by respective exclusive drive motors 88, 90, so that the two EC-supply tables 68, 70 are moved independent of each other. The respective rotation amounts of the two drive motors 88, 90 are detected by respective encoders 92, 94 (Fig. 4), so that the EC-supply tables 68, 70 are accurately stopped at respective arbitrary positions in each of a common EC-supply area and a right-hand and a left-hand waiting area all of which will be described later.

In Fig. 2, reference numeral 96 designates a while circle which represents an EC-supply position which is near to the lengthwise middle portion of the table guide 80 and where each of the two EC-supply tables 68, 70 supplies the ECs to the EC mounting device 32. When the ECs are mounted on the PWB 22, the two EC-supply tables 68, 70 are moved to position each of the respective EC-supply portions of the EC feeders 64 at the EC-supply position 96. As schematically shown in Fig. 3, the above-indicated EC-supply area that is common to the two EC-supply tables 68, 70 includes the EC-supply position 96, and corresponds to the widest area in which each of the two EC-supply tables 68, 70 should be moved to supply the ECs, i.e., moved to position, at the EC-supply position 96, each of the two EC feeders 64 located at the opposite ends thereof as seen in the X-axis direction. The two EC-supply tables 68, 70 are alternately moved in the EC-supply area, to supply the ECs. While one of the two tables 68, 70 supplies the ECs in the EC-supply area, the other table waits in a corresponding one of the two waiting areas provided on both sides of, and adjacent to, the EC-supply area, on the table guide 80, so that the other table does not interfere with the EC supplying operation of the one table. The right-hand waiting area and the left-hand waiting area are exclusive for the first and second EC-supply tables 68, 70, respectively, so that the first table 68 is moved to the right waiting area and is not moved to the left waiting area, and the second table 70 is moved to the left waiting area and is not moved to the right waiting area. The table guide 80 has a length sufficient for the two tables 68, 70 to move between the EC-supply area and the corresponding waiting areas. The table guide 80 provides a table guiding device.

When, for example, at least one of the EC feeders 64 supported by each of the two EC-feed tables 68, 70 has supplied all the ECs held thereby, the each table 68, 70 cannot continue the current EC supplying operation. Then, the each table 68, 70 is moved to the corresponding waiting area, so that an operator replaces the one feeder 64 with a new feeder 64 or supplies the one feeder 64 with a new EC-tape reel 72. As schematically illustrated in Fig. 3, the two waiting areas can be covered by a cover member 100 which can be opened and closed by the operator. The opening and closing of the cover member 100 is detected by a cover detecting device 102 (Fig. 4). The cover detecting device 102 may be a cover-open-and-close sensor including a transmission-type photoelectric switch which includes a light emitter and a light receiver. The cover member 100 is provided by a substantially transparent plate which is provided with a light reflecting member. When the cover member 100 is fully closed, the light reflecting member as part of the cover member 100 reflects the light emitted by the light emitter, so that the photoelectric switch or the cover detecting device 102 generates an OFF signal indicating that the cover member 100 is closed. On the other hand, when the cover member 100 is opened at least partly, the photoelectric switch or the detecting device 102 generates an ON signal indicating that the cover member 100 is opened. The transmission-type photoelectric switch is a sort of non-contact-type detection switch, and the cover detecting device 102 may be provided by a different sort of non-contact-type switch, such as a reflection-type photoelectric switch or a proximity switch. Otherwise, the cover detecting device 102 may be provided by a contact-type switch, such as a limit switch.

A shutter member 104 is provided between the EC-supply area and each of the right and left waiting areas. Each of the two shutter members 104 is moved upward and downward by an elevating and lowering device 16 (Fig. 4). When each shutter member 104 is moved to, and held at, its lower-end, i.e., closing position, a lower end of the each shutter member 104 is positioned adjacent to an upper surface of the table guide 80, so that the operator who is operating in the corresponding waiting area is prevented from contacting the EC-supply tables 68, 70 or the EC feeders 64 thereon. On the other hand, when the each shutter member 104 is moved to, and held at, its upper-end, i.e., opening position, the each shutter member 104 is positioned above the EC feeders 64 attached to the EC-supply tables 68, 70 supported on the table guide 80, so that the supply tables 68, 70 are allowed to move between the EC-supply area and the corresponding waiting areas.

The EC mounting system constructed as described above is controlled by a control device 110 shown in Fig. 4. The control device 110 is essentially provided by a computer 120 including a processing unit ("PU") 112, a read only memory ("ROM") 114, a random access memory ("RAM") 116, and a bus 118 connecting those elements 112, 114, 116 with one another. An input interface 126 is connected to the bus 118. The respective encoders 92, 94 of the drive motors 88, 90, and the cover detecting device 102 are connected to the input interface 126. In addition, a table-end detecting device 128, a tape-end detecting device 130, and an operation panel 132 are connected to the input interface 126. The tape-end detecting device 130 detects that each of the EC feeders 64 has supplied all ECs, that is, that each of the EC feeders 64 is having no ECs. The operation panel 132 includes various operable portions, such as an operation-start-and-end switch and an input device for inputting various sorts of data such as the sort of a PWB 22 on which ECs are to be mounted. The table-end detecting device 128 as a sort of abnormal-proximity detecting device which detects an abnormal proximity of the two EC-supply tables 68, 70 is identical with that disclosed in Japanese Patent Publication No. 10-34456, and will be briefly described below.

The table-end detecting device 128 includes (a) a transmission-type photoelectric switch including a light emitter and a light receiver which are provided on one of opposite end portions of one of the two EC-supply tables 68, 70 which one end portion is opposed to the other EC-supply table 70, 68; and (b) a light interrupting member which is provided on one of opposite end portions of the other EC-supply table 70, 68 which one end portion is opposed to the one end portion of the one EC-supply table 68, 70. When the light interrupting member enters a space provided between the light emitter and the light receiver of the photoelectric switch, and thereby prevents the light receiver from detecting the light emitted by the light emitter, the table-end detecting device 128 detects an abnormal proximity of the two EC-supply tables 68, 70, and produces an abnormality signal indicating the detected abnormal proximity. Based on the abnormality signal produced by the table-end detecting device 128, the control device 110 stops the two EC-supply tables 68, 70, thereby preventing the two tables 68, 70 from colliding with each other. The tape-end detecting device 130 as an EC-end detecting device detects that each EC feeder 64 has supplied all ECs and is having no ECs. Thus, the tape-end detecting device 130 provides a sort of detecting device which detects that each EC feeder 64 has become unable to supply ECs. In the present embodiment, when the EC suction heads 32 of the index table 30 have failed to suck an EC, two successive times, from an EC feeder 64, the tape-end detecting device 130 detects the end of the EC tape fed by that EC feeder 64, and produces a tape-end signal.

The bus 118 is connected to an output interface 140 which in turn is connected to the board carry-in device 14, the board carry-out device 16, the board positioning and supporting device 18 including the X-Y table 42 and the board stopping device 50, the index servomotor 34, the drive motors 88, 90, the elevating and lowering devices 106 for the shutter members 104, and a display device 154, via respective drive circuits141, 142, 143, 144, 145, 146, 147, 148, and 149. The display device 154 includes a buzzer (or an indicator lamp) or a CRT (cathode ray tube), and functions as an informing device which informs the operator that the first or second EC-supply table 68, 70 has an EC feeder 64 which has supplied all ECs. Although the control device 110 additionally controls the EC mounting device 12, illustration thereof is omitted from Fig. 4.

The ROM 114 of the control device 110 stores (a) respective sorts of ECs to be mounted on each PWB 22, (b) EC-mount places prescribed on the each PWB 22, (c) order of mounting of the ECs, (d) order of moving of the PWB 22, (e) a program for moving the two EC-supply tables 68, 70 to supply the ECs to the EC mounting device 12 according to the order of mounting of the ECs, and (f) a program for deferring the supplying of ECs from an EC feeder 64 which has supplied all ECs and is having no ECs, and causing the next EC feeder 64, in the order, to supply ECs. In addition, the ROM 114 stores a table-movement inhibiting program for inhibiting, when the operator needs to perform an operation, such as replacing, on one EC-supply table 68, 70 waiting in one waiting area, one EC feeder 64 with a new EC feeder 64, the one EC-supply table 68, 70 from moving into the EC-supply area until the operator inputs information indicating that the operator has finished the operation, e.g., the replacement of the EC feeders 64, and allowing the one EC-supply table 68, 70 to move into the EC-supply area when the operator inputs that information. In the present embodiment, the operator opens the cover member 100 for replacing EC feeders 64 with each other, and the cover detecting device 102 detects the opening of the cover member 100 and produces a cover-opening signal indicating that the cover member 100 is open. Based on the cover-opening signal, the control device 110 inhibits the one EC-supply table 68, 70 from moving into the EC-supply area. When the operator finishes his or her operation and closes the cover member 100, the cover detecting device 102 detects the closing of the cover member 100 and produces a cover-closing signal indicating that the cover member 100 is closed. Based on the cover-closing signal, the control device 110 allows the one EC-supply table 68, 70 to move into the EC-supply area. Thus, the closing of the cover member 100 by the operator means the inputting of the information that the operator has finished his or her operation on one EC-supply table 68, 70 waiting in one waiting area. The cover member 100 functions as a switch member which is manually operable for switching the control device 110 to inhibit the movement of each EC-supply table 68, 70, or to allow the movement of the each EC-supply table 68, 70. Moreover, the ROM 114 stores a shutter-open-and-close program for opening and closing each of the two shutter members 104, according to the opening and closing of the cover member 110. In the present embodiment, the buzzer of the display device 154 makes a sound to inform the operator that the first or second EC-supply table 68, 70 includes an EC feeder 64 which has supplied all ECs. Alternatively, the indicator lamp of the display device 154 is blinked for the same purpose. When the operator performs his or her operation, such as replacing EC feeders 64 with each other, he or she opens the cover member 100, so that the corresponding shutter member 104 is closed and the corresponding EC-supply table 68, 70 is inhibited from moving into the EC-supply area. When the operator finishes his or her operation, such as replacing EC feeders 64 with each other, and closes the cover member 100, the shutter member 104 is opened and the EC-supply table 68, 70 is allowed to move into the EC-supply area.

Furthermore, the ROM 114 stores a PWB conveying program for conveying a PWB 22. The PWB conveying program includes a special-operation program for performing a special operation on a PWB 22. The special-operation program is for carrying out a first PWB 22 from the board-support table 40 to the carry-out conveyor 46 on the downstream-side of the support table 40, carrying in a second PWB 22 from the carry-in conveyor 44 onto the support table 40, then returning the secondPWB 22 from the support table 40 to the carry-in conveyor 44 on the upstream-side of the table 40, and returning the first PWB 22 from the carry-out conveyor 46 to the support table 40.

The table guide 80, the feed screws 84, 86, the nut 82, and the drive motors 88, 90 cooperate with one another to provide a table moving device; and the programs for moving the EC-supply tables 68, 70 and a portion of the control device 110 that performs those programs cooperate with each other to provide a table-moving-device control device. The above-indicated table-moving inhibiting program and a portion of the control device 110 that performs that program cooperate with the cover member 100 as the manually operable switch member to provide a table-movement inhibiting device. Moreover, the programs for conveying the PWBs 22 and a portion of the control device 110 that performs those programs cooperate with the board carry-in device 14, the board carry-out device 16, and the board positioning and supporting device 18 to provide a PWB conveying device; and the above-indicated special-operation program and a portion of the control device 110 that performs that program cooperate with each other to provide a special-operation control device.

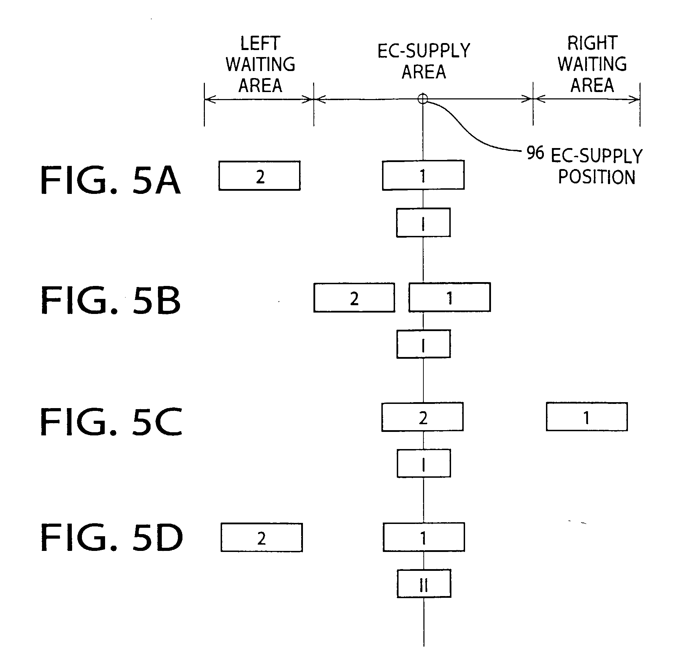

Hereinafter, the operation of the present EC mounting system constructed as described above will be described by reference to Figs. 5 to 7. In Figs. 5 to 7, the first and second EC-supply tables 68, 70 are indicated at elongate rectangles numbered "1" and "2", respectively, in the order of supplying of ECs to each PWB 22; and three PWBs 22 are indicated at respective short rectangles numbered "I", "II", "III", respectively, in the order of conveying thereof in the PWB-convey direction.

First, a normal EC supplying operation will be described by reference to Figs. 5A, 5B, 5C, and 5D. Before an EC supplying operation is started, the first and second EC-supply tables "1", "2" are kept in the right and left waiting areas, respectively. First, as shown in Fig. 5A, a first PWB "I" is positioned at the EC-mount station, and the first EC-supply table "1" is moved from the right waiting area to the EC-supply area, so that the EC feeders 64 on the first table "1" are sequentially positioned at the EC-supply position 96 to supply the ECs to the EC mounting device 12, which receives the ECs and mounts the ECs on the prescribed EC-mount places on the first PWB "I". As shown in Fig. 5B, at a terminal stage of supplying of ECs by the first table "1", the second EC-supply table "2" is moved from the left waiting area to the EC-supply area, so that the second table "2" follows the first table "1" which is supplying the ECs, while keeping more than a predetermined distance between the two tables "1", "2". Thus, the second table "2" is prepared for replacing the first table "1" and supplying the ECs in place of the first table "1". At the step shown in Fig. 5B, the second table "2" follows the first table "1", while being moved at an acceleration and a deceleration which are lower than an acceleration and a deceleration at which the first table "1" is moved. Thus, the two tables "1", "2" produce only smaller vibration and noise than those which would be produced by the same "1", "2" when both of them are moved at the same acceleration and deceleration. However, immediately before the timing at which the two tables "1", "2" are replaced with each other, the two tables "1", "2" are moved in synchronism with each other so that they can be quickly replaced with each other. Alternatively, the two tables "1", "2" may be moved in synchronism with each other, all the time when they are moved near, and with, each other in the component-supply area. In the latter case, it is preferred that the two tables "1", "2" be moved in synchronism with each other, at an acceleration and a deceleration which are lower than an acceleration and a deceleration at which the first table "1" is solely moved.

After the first table "1" finishes the supplying of ECs, the first table "1" is replaced with the second table "2" and, as shown in Fig. 5C, the first table "1" is moved from the component-supply area to the right waiting area. The EC feeders 64 on the second table "2" are sequentially positioned at the EC-supply position 96, so that the EC feeders 64 supply the ECs. At a terminal stage of the EC-supply period or duration in which the second table "2" supplies the ECs, the first table "1" follows the second table "2" and is prepared for replacing the second table "2", in the same manner as described above by reference to Fig. 5B. After the second table "2" finishes the supplying of ECs, the second table "2" is, as shown in Fig. 5D, moved from the component-supply area to the left waiting area, and the first table "1" is moved from the right waiting area to the EC-supply area. In addition, the first PWB "I" completed in the EC-mount station is conveyed from the station to a downstream side thereof, and the second PWB "II" is conveyed to the station from an upstream side thereof and is positioned thereat. Thus, the second PWB "II" is prepared for the mounting of ECs thereon. The above-described steps are repeated, and the ECs are mounted on the PWBs 22.

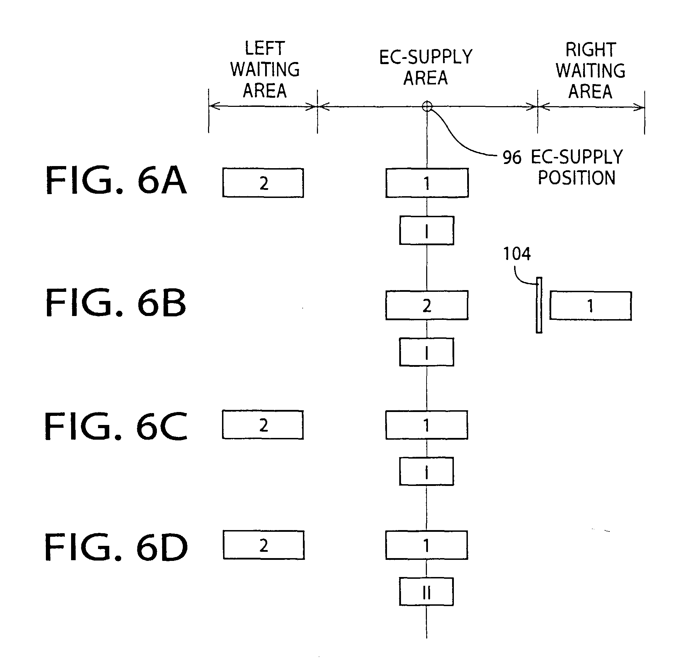

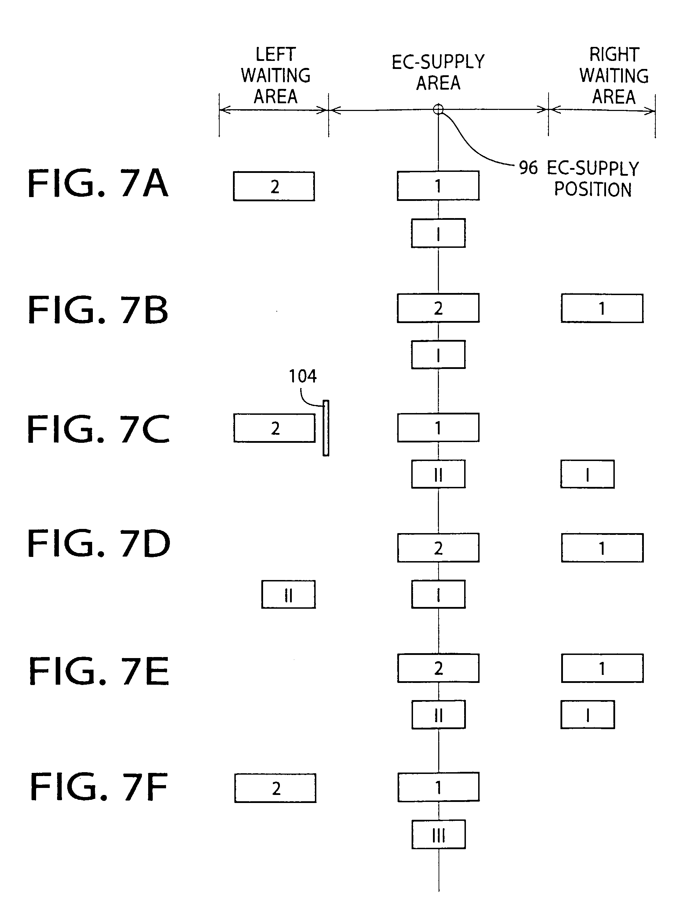

Next, there will be described, by reference to Figs. 6A, 6B, 6C, 6D, 7A, 7B, 7C, 7D, 7E, and 7F, the manner in which the EC supplying apparatus 20 is operated in a special case where while one of the first and second tables "1", "2" supplies ECs in the EC-supply area, at least one of the EC feeders 64 on the one table has supplied all the ECs and therefore is having no ECs. However, no detailed description of the same steps as those described above by reference to Figs. 5A-5D, such as the replacement of the two tables "1", "2", is provided.

First, there will be described, by reference to Figs. 6A, 6B, 6C, and 6D, a first special case where one of the EC feeders 64 on the first table "1" has supplied all the ECs. At the step shown in Fig. 6A, the first table "1" supplies the ECs, like at the step shown in Fig. 5A. If, during the supplying of ECs by the first table "1", the tape-end detecting device 130 produces a detection signal indicating that one of the EC feeders 64 on the first table "1" has supplied all the ECs, the control device 110 defers the supplying of one or more ECs from the one EC feeder 64. The control device 110 stores identification data identifying the one EC feeder 64, in an appropriate portion of the RAM 116. However, the control device 110 continues the supplying of ECs from the remaining EC feeders 64 on the first table "1". After the first table "1" finishes the supplying of ECs from all the EC feeders 64 thereon except for the one EC feeder 64 having no ECs, the first table "1" is replaced with the second table "2", in the same manner as that described above by reference to Figs. 5B, 5C, and the first table "1" is moved from the EC-supply area to the right waiting area. At this time, the buzzer of the display device 154 produces a sound to inform the operator of the fact that the first table "1" includes the one EC feeder 64 having no ECs. In addition, the display device 154 displays, based on the identification data stored in the RAM 116, the identification number identifying the one EC feeder 64. While the second table "2" supplies the ECs as shown in Fig. 6B, the operator replaces, on the first table "1" kept still in the right waiting area, the one EC feeder 64 with a new one 64, or replenishes the one EC feeder 64 with new ECs. When the operator opens the cover member 100, the control device 110 closes the shutter member 104 provided between the right waiting area and the EC-supply area, and inhibits the first table "1" from moving from the right waiting area into the EC-supply area. When the operator's operation on the one EC feeder 64, such as the replacement of the EC feeders 64, is finished and the one EC feeder 64 has been placed in the state in which the one EC feeder 64 is able to supply ECs, the operator closes the cover member 100, so that the shutter member 104 is opened and the first table "1" is allowed to move into the EC-supply area.

After the second table "2" finishes the supplying of ECs, the second table "2" is replaced with the first table "1", as shown in Fig. 6C, and the one EC feeder 64 the supplying of one or more ECs from which was deferred is positioned at the EC-supply position 96, so that the one EC feeder 64 supplies the one or more ECs. Then, as shown in Fig. 6D, in the state in which the first table "1" is positioned in the EC-supply area, the first PWB "I" is carried out and the second PWB "II" is carried in to the EC-mount station, so that the first table "1" starts supplying ECs to the second PWB "II".

Thus, the above-described method assures that while one of the two tables "1", "2" supplies the ECs, the other table can be kept still in the corresponding waiting area, so that the operator can stably perform his or her operation, such as the replacement of EC feeders 64. Therefore, the two tables "1", "2" can be continuously used to supply the ECs, which leads to improving the efficiency of supplying of ECs. In addition, since the supplying of one or more ECs from one EC feeder 64 which has become unable to supply any ECs is deferred, the time of replacement of the two tables "1", "2" is only one that is the same as the time of replacement of the two tables "1", "2" when the first table "1" has no such EC feeders 64 which are unable to supply any ECs. This also improves the efficiency of supplying of ECs.

Second, there will be described, by reference to Figs. 7A, 7B, 7C, 7E, and 7F, a second special case where one of the EC feeders 64 on the second table "2" has supplied all the ECs. After the first table "1" finishes the supplying of ECs, as shown in Figs. 7A and 7B, the first table "1" is replaced with the second table "2", and the second table "2" starts supplying ECs. If, during the supplying of ECs by the second table "2", the tape-end detecting device 130 produces a detection signal indicating that one of the EC feeders 64 on the second table "2" has supplied all the ECs, the control device 110 defers the supplying of one or more ECs from the one EC feeder 64, stores identification data identifying the one EC feeder 64, in an appropriate portion of the RAM 116, and continues the supplying of ECs from the remaining EC feeders 64 on the second table "2", in the same manner as described above by reference to Figs. 6A-6D. After the second table "2" finishes the supplying of ECs from all the EC feeders 64 thereon except for the one EC feeder 64 having no ECs, the second table "2" is replaced with the first table "1", the second table "2" is moved from the EC-supply area to the left waiting area, as shown in Fig. 7C, and the first table "1" is positioned at the EC-supply position. The first PWB "I" is carried out and the second PWB "II" is carried in to the EC-mount station, so that the first table "1" starts supplying the ECs for being mounted on the second PWB "II". In the left waiting area, the operator opens the cover member 100, so that the shutter member 104 provided between the left waiting area and the EC-supply area is closed. The operator performs his or her operation such as the replacement of EC feeders 64.

After the operator finishes his or her operation in the left waiting area and closes the cover member 100 and additionally the first table "1" finishes the supplying of ECs for being mounted on the second "II", the first table "1" is replaced with the second table "2", as shown in Fig. 7D, and the incomplete PWB "II" is returned from the EC-mount station to the upstream side and concurrently the incomplete PWB "I" is returned to the EC-mount station from the downstream side. The second table "2" supplies, for the first PWB "I", one or more ECs from the one EC feeder 64 the supplying of the one or more ECs from which had been deferred. Thus, the first PWB "I" is completed. Then, as shown in Fig. 7E, in the state in which the second table "II" remains in the EC-supply area, the first PWB "1" is carried out from the EC-mount station to the downstream side, and the second PWB "II" which had received the ECs from the first table "1" is re-positioned at the EC-mount station. Then, the second table "2" supplies the ECs to the second PWB "II", so that the second PWB "II" is completed. Alternatively, in the state in which the second PWB "II" which has received the ECs from the first table "1" remains positioned at the EC-mount station, the second table "2" may supply ECs to the second PWB "II" and, after the incomplete, first PWB "I" is returned from the downstream side to the EC-mount station, the second table "2" may supply, for the first PWB "I", one or more ECs from the one EC feeder 64 the supplying of the one or more ECs from which had been deferred. In either case, after the supplying of ECs for the second PWB "II" is finished, the second table "2" is replaced with the first table "1", as shown in Fig. 7F, and the third PWB "III" is carried in, and positioned at, the EC-mount station, so that the first table "1" starts supplying ECs for being mounted on the third PWB "III".

Thus, even if, during the supplying of ECs by the second table "2", one of the EC feeders 64 on the second table "2" may have supplied all the ECs, the two tables "1", "2" can continuously supply the ECs, which leads to improving the efficiency of supplying of ECs. The method described above by reference to Figs. 7A-7F requires one more forward and backward movement of each PWB 22, as compared with the case where no EC feeders 64 of the second table "2" become unable to supply any ECs. However, the lowering of the efficiency of supplying of ECs, caused by this method, is much smaller than that caused by interrupting the EC supplying operation for the replacement of EC feeders 64.

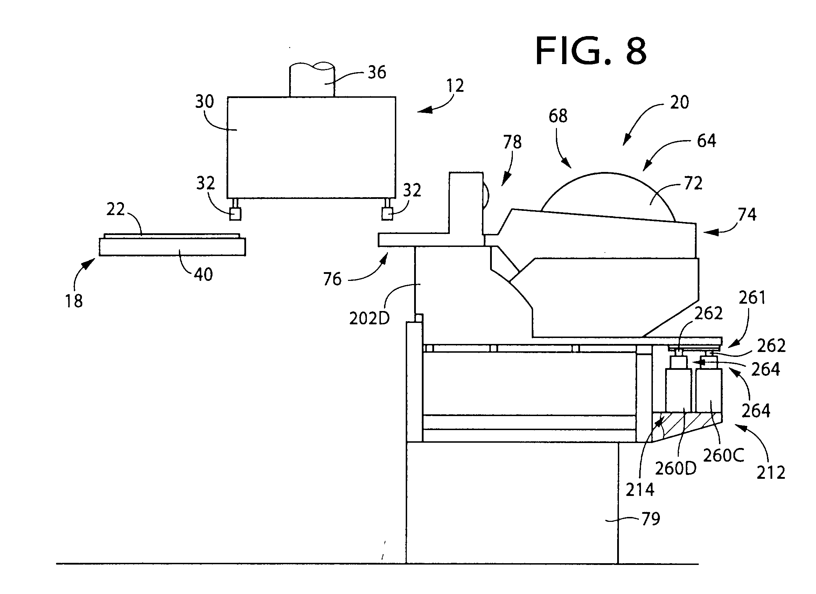

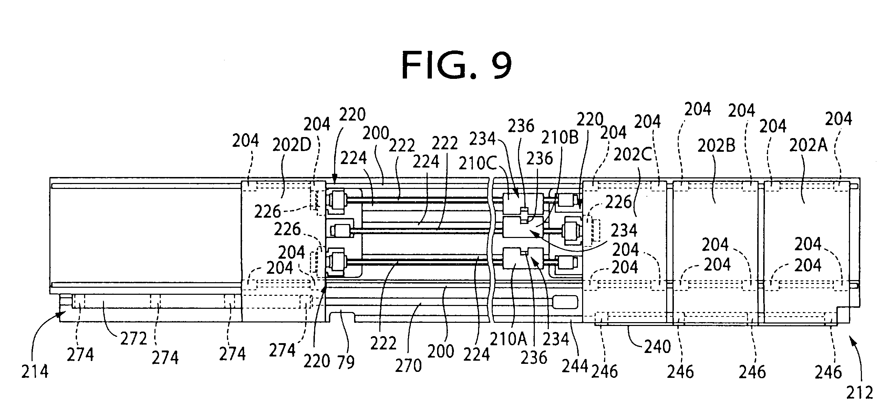

Hereinafter, there will be described the second embodiment of the present invention, which also relates to an EC mounting system including an EC supplying apparatus. The present EC supplying apparatus employs three or more EC-supply tables which cooperate with one another to supply ECs to each PWB 22. Figs. 8 and 9 show an EC supplying apparatus which employs four EC-supply tables 202A, 202B, 202C, 202D, as an example of the above-indicated EC supplying apparatus. The present EC mounting system employs the same EC mounting device and the same board conveying device as those employed in the first embodiment shown in Figs. 1 to 7. The same reference numerals as used for the first embodiment are used to designate the corresponding elements and parts of the second embodiment, and the description and illustration thereof is omitted. Since the EC supplying apparatus employed in the second embodiment is substantially the same as that disclosed in Japanese Patent Publication No. 10-34456, the construction of the EC supplying apparatus will be briefly described below.

As shown in Fig. 9, two linear table guide rails 200 as table guide members are provided on a bed 79 such that the two guide members 200 extend parallel to each other in an X-axis direction and are distant from each other in a Y-axis direction perpendicular to the X-axis direction. Four EC-supply tables 200A, 200B, 200C, 200D are supported on the two guide rails 200 such that each of the tables 200A-200D is movable in the X-axis direction. Each table 200A-200D has four guide blocks 204 which are fixed thereto such that a first pair of blocks 204 are distant from a second pair of two guide blocks 204 in the Y-axis direction and the two blocks of each of the first and second pairs are distant from each other in the X-axis direction. The four guide blocks 204 provide guided members of each table 200A-200D. The four guide blocks of each table 200A-200D are fitted on the guide rails 200, such that each table is slideable on the rails 200. A plurality of EC feeders 64 are attached to each table 200A-200D, such that respective EC-supply portions of the feeders 64 are arranged along a straight line parallel to the X-axis direction. The EC feeders 64 are not shown in Fig. 9.

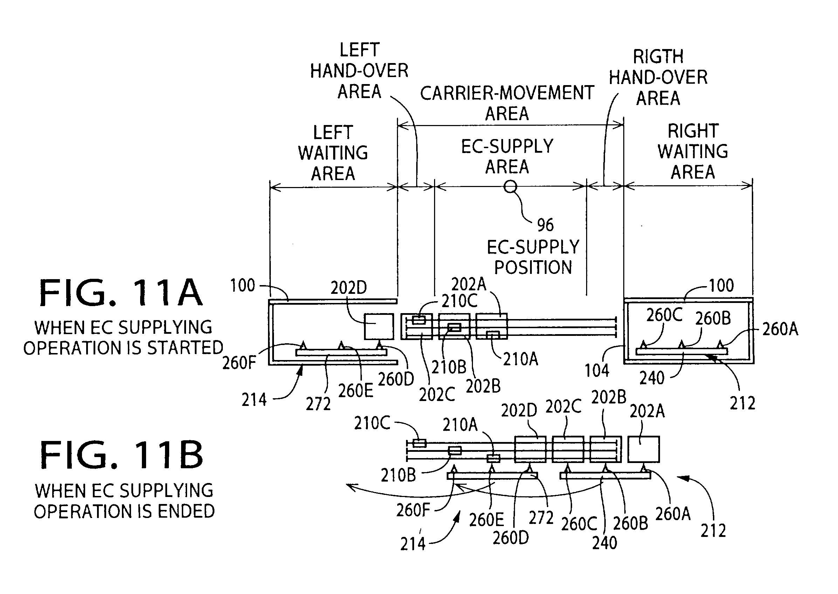

Fig. 11A and Fig. 11B show a carrier-movement area which includes, on both sides of an EC-supply position 96, a right half area whose length in the X-axis direction is equal to the sum of respective lengths of three tables 200, and a left half area whose length in the X-axis direction is likewise equal to the sum of respective lengths of three tables 200. The carrier-movement area includes an EC-supply area as a central portion whose length is equal to the sum of respective lengths of four tables 200, and a right and a left hand-over area on both sides of the EC-supply area, respectively, in the X-axis direction. A right waiting area and a left waiting area each of which has a length equal the sum of respective lengths of three tables 200 are provide on both sides of the carrier-movement area, respectively, in the X-axis direction. Fig. 9 shows a state in which the tables 202A, 202B, 202C are kept still in the right waiting area and the table 202D is kept still in the left waiting area.

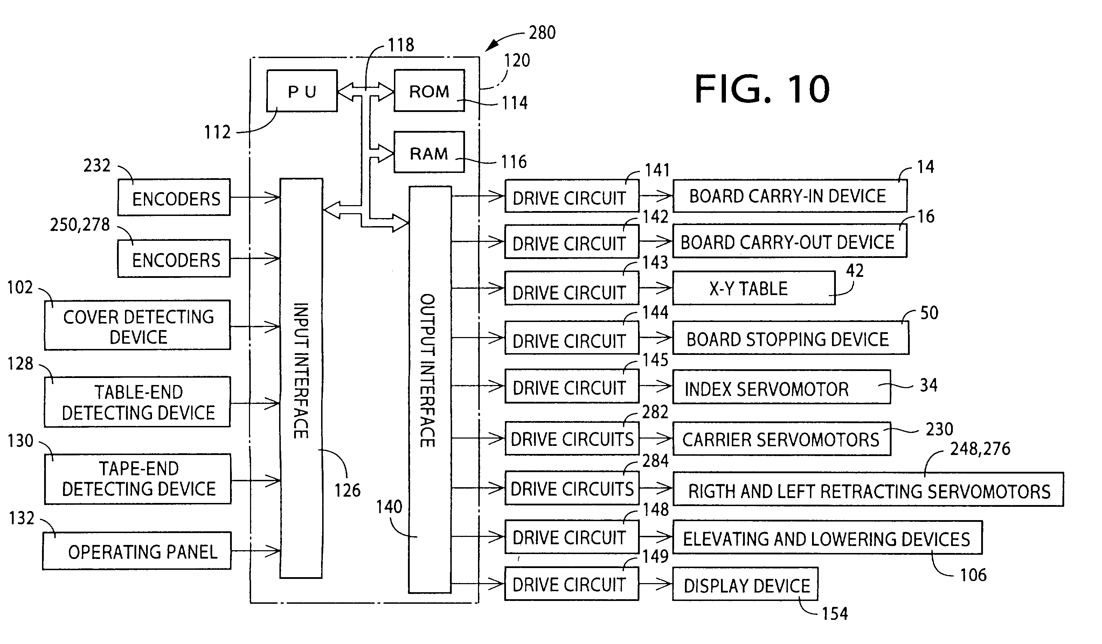

On the bed 79, there are provided there carriers 210A, 210B, 210C, a right table retracting device 212, and a left table retracting device 214. Each of the three carriers 210A-210C is moved in the carrier-movement area by a carrier moving device 220. The carrier moving device 220 includes three feed screws 222 which extend over the entire carrier-movement area; three screw drive devices; and three nuts fixed to the three carriers 210A-210C. The three feed screws 222 extent parallel to the two table guide rails 200, and parallel to one another. The feed screws 222 are attached to the bed 79 such that each screw 222 is rotatable about a horizontal axis line thereof and is not movable in directions parallel to the horizontal axis line. Three carrier guide rails 224 are provided on the bed 79, such that each of the carrier guide rails 224 extends parallel to the feed screws 222, and respective guide blocks as guided members fixed to respective lower surfaces of the three carriers 210A-210C are fitted on the three carrier guide rails 224, respectively, such that each of the carriers 210A-210C is slideable on the corresponding carrier guide rail 224. The carrier guide rails 224 extend over the entire carrier-movement area. Each of the there feed screws 222 is connected to a corresponding one of three carrier servomotors 230 (Fig. 10) as drive sources via a corresponding one of there rotation transmitting devices each of which includes a timing pulley 226 and a timing belt. When each of the carrier servomotors 230 is operated or rotated, the corresponding feed screw 222 is rotated. The three rotation transmitting devices and the there carrier servomotors 230 cooperate with each other to provide the there screw drive devices, respectively. Respective rotation amounts of the thee carrier servomotors 230 are detected by three encoders 232 (Fig. 19), respectively, and the three carriers 210A-210C are accurately stopped at respective arbitrary positions in the carrier-movement area. The three carriers 210A-210C are provided with respective engaging devices 234 each of which can engage a corresponding one of three engageable portions (not shown) formed in the lower surface of each of the tables 200A-200D. Each of the carrier-associated engaging devices 234 includes an engageable portion 236 which is moved by a moving device (not shown) to a first position where the engageable portion 236 can engage each table 200-200D and to a second position where the engageble portion 236 cannot engage each table 200A-200D. Each of the three moving devices may include an air-operated cylinder device. The three engageable portions of each of the tables 200A-200D are formed at an intermediate position on the lower surface of the each table as seen in the X-axis direction, and respective positions corresponding to the respective engageable portions 236 of the three engaging devices 234 as seen in the Y-axis direction. More specifically described, each of the three engageable portions of each of the tables 200A-200D is provided by a groove into, and, and out of, which a piston rod of the air-operated cylinder device of each of the three engaging devices 234 is projected and retracted. When each one of the carriers 210A-210C is moved in the state in which the engagable portion 236 of the engaging device 234 of the each one carrier is engaged with each one of the four tables 202A-202D, the each one table is moved in the carrier-movement area.

The right table retracting device 212 includes a right movable member 240 and a right-movable-member moving device. In rear of the pair of table guide rails 200, that is, on a remote side of the table guide rails 200 from the EC mounting device 12, a right-movable-member guide rail 244 is provided on the bed 79 such that the guide rail 244 extends over the right waiting area and the carrier-movement area. The right movable member 240 is supported on the guide rail 244 such that the right member 240 is movable in the X-axis direction. The right movable member 240 has a plate-like shape having a length slightly shorter than the sum of respective lengths of three tables 202, and has four guide blocks 246 which are fixed to a lower surface of the member 240. The four guide blocks 246 provide four guided members of the member 240. The right member 240 is fitted on the guide rail 244 via the guide blocks 246, such that the right member 240 is movable in the X-axis direction. Since the right-movable-member moving device is the same as disclosed in Japanese Patent Publication No. 10-34456, the detailed description and illustration thereof is omitted. In short, the right-movable-member moving device includes two timing pulleys as two rotatable members that are provided at an end of the carrier-movement area that is adjacent to the left waiting area; two timing pulleys as two rotatable members that are provided at an end of the right waiting area that is remote from the carrier-movement area; and an endless timing belt as a wound-on member that is wound on the four timing pulleys. The right movable member 240 is connected by a connecting device (not shown) to an upper one of two horizontal portions of the endless timing belt that extend parallel to the table guide rails 200. One of the two timing pulleys provided at the end of the right waiting area is rotated by a right retracting servomotor 248 (Fig. 10) as a drive source. When the right retracting servomotor 248 is operated or rotated, the timing pulleys are rotated and the timing belt is moved, so that the right movable member 240 is moved in the right waiting area and the carrier-movement area. An amount of rotation of the servomotor 248 is detected by an encoder 250 (Fig. 10), and the right movable member 240 can be accurately stopped at an arbitrary position in the right waiting area and the carrier-movement area.

Three engaging devices 260A, 260B, 260C are provided on the right movable member 240, at a regular interval longer than the length of each table 202 (i.e., the dimension of each table 202 in the X-axis direction), as shown in Figs. 11A, 11B. The three engaging devices 260A, 260B, 260C have an identical construction and, as shown in Fig. 8, each engaging device 260 includes an engagable portion 262 which is engageable with an engageable groove as an engageable portion 261 that is formed in the lower surface of each of the tables 202A-202D; and a moving device 264 which moves the engageable portion 262 to a first position where the engageable portion 262 can engage each table 202A-202D and to a second position where the portion 262 cannot engage each table 202A-202D. Each of the three moving devices 264 may include an air-operated cylinder device.

The left table retracting device 214 includes a left-movable-member guide rail 270 which is provided, on the bed 79, in front of the right-movable-member guide rail 244, that is, at a position nearer to the table guide rails 200 than the right guide rail 244. The left-movable-member guide rail 270 extends over the left waiting area and the entire carrier-movement area. Like the right-movable- member retracting device 212, the left-movable-member retracting device 214 includes a left movable member 272, guide blocks 274, a left-movable-member moving device, and three retraction-associated engaging devices 260D, 260E, 260F. In Fig. 9, the retraction-associated engaging devices 260D-260F are not shown; and, in Fig. 8, only the engaging device 26D is shown as a representative. Like the right- movable-member moving device, the left-movable-member moving device includes two timing pulleys as two rotatable members that are provided at the other end of the carrier-movement area that is adjacent to the right waiting area; two timing pulleys as two rotatable members that are provided at an end of the left waiting area that is remote from the carrier-movement area; and an endless timing belt as a wound-on member that is wound on the four timing pulleys. The left movable member 272 is connected by a connecting device (not shown) to an upper one of two horizontal portions of the endless timing belt that extend parallel to the table guide rails 200. One of the two timing pulleys provided at the end of the left waiting area is rotated by a left retracting servomotor 276 (Fig. 10) as a drive source. An amount of rotation of the servomotor 276 is detected by an encoder 278 (Fig. 10), and the left movable member 272 can be accurately stopped at an arbitrary position in the left waiting area and the carrier-movement area. Three engaging devices 260D, 260E, 260F are provided on the left movable member 240. As shown in Fig. 8, each of the engaging devices 260A, 260B, 260C engages a rear portion of the groove 261 of each of the tables 202A-202D as seen in the Y-axis direction, and each of the engaging devices 260D, 260E, 260F engages a front portion of the groove 261 of each of the tables 202A-202D. Since the two table retracting devices 212, 214 are offset from each other as seen in the Y-axis direction, the two devices 212, 214 are prevented from interfering with each other.

As shown in Figs. 11A, 11B, the right and left waiting areas are covered by-a cover member 100 which can be opened and closed, like in the first embodiment shown in Figs. 1 to 7. Two shutter members 104 (only one shutter member 104 is shown in Fig. 11A) are provided between the carrier-movement area and each of the right and left waiting areas.

The present EC mounting system includes a control device 280, as shown in Fig. 10, which includes an input interface 126 to which the respective encoders 232 of the three carrier servomotors 232 and the respective encoders 250, 278 of the right and left retracting servomotors 248, 276 are connected; and an output interface 140 to which the three carrier servomotors 230, the right and left retracting servomotors 248, 276, the respective moving devices of the carrier-associated engaging devices 236, and the respective moving devices of the retraction-associated engaging devices 262 are connected via respective drive circuits 282, 284. Since the other elements connected to the control device 280 are the same as those employed in the first embodiment, only the illustration thereof is provided in Fig. 10 and the detailed description thereof is omitted.

In the second embodiment, the table guide rails 200, the carriers 210A-210C, the carrier moving device 220, the right table retracting device 212, and the left table retracting device 214 cooperate with one another to provide a table moving device; and various programs which are stored in the ROM 114 of the control device 280 and are used to move the EC-supply tables 202A-202D, and a portion of the control device 280 that carries out those programs cooperate with each other to provide a table-moving-device control device.

Next, the operation of the EC mounting system constructed as described above will be described.

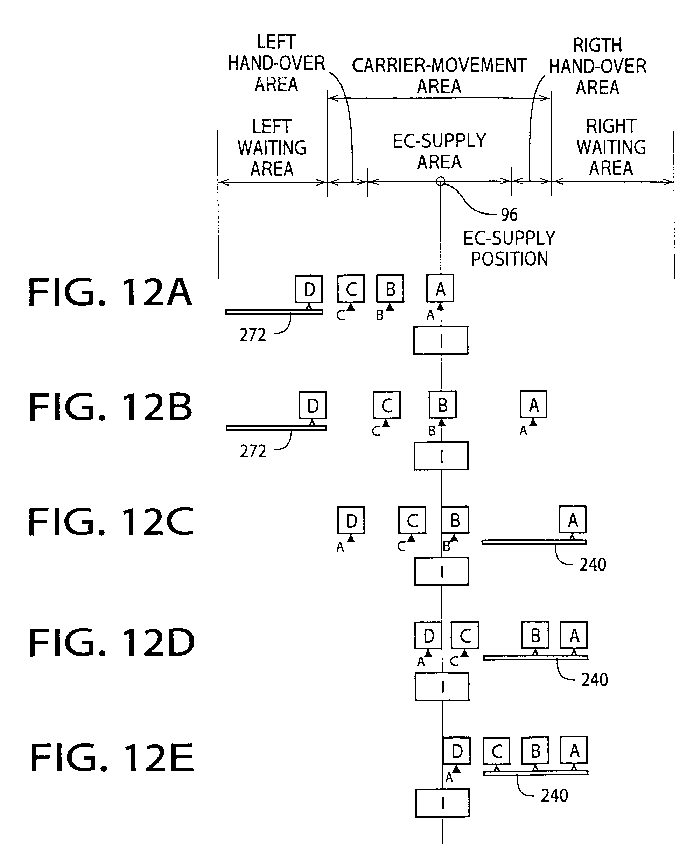

First, a normal EC supplying operation will be described by reference to Figs. 11A, 11B, 12A, 12B, 12C, 12D, and 12E. In those figures, the four tables 202A, 202B, 202C, 202D are indicated at quadrangles; one or more of the carriers 210A-210C that is or are currently engaged with one or more of the tables 202A-202D is or are indicated at black triangles; and one or more of the engaging devices 260A-260F of the right and left table retracting devices 212, 214 that is or are currently engaged with one or more of the tables 202A-202D is or are indicated at white triangles. The four tables 202A-202D are labeled with corresponding alphabets, "A", "B", "C", and "D", in the order of supplying of ECs for each PWB 22; and the two PWBs 22 are indicated at respective rectangles numbered "I" and "II", in the order of conveying thereof in the board-convey direction, like in the first embodiment. In addition, the same steps as those described above in connection with the first embodiment shown in Figs. 1 to 7, such as the replacement of the tables 202A-202D, will not be described in detail again.

Before an EC supplying operation is started, the tables 202A-202D are positioned at an EC-supply start position, as shown in Fig. 11A. First, as shown in Fig. 12A, the table "A" is moved by the carrier 210A and is positioned at the EC-supply position 96 where the table "A" supplies ECs for being mounted on the first PWB "I" positioned at the EC-mount station. At a terminal stage of an EC-supply period or duration in which the table "A" supplies the ECs, the table "B" is moved by the carrier 210B to follow the table "A", in the same manner as described above by reference to the first embodiment shown in Figs. 1 to 7. When the table "A" finishes the supplying of ECs, the two tables "A", "B" are moved in synchronism with each other, so that the table "A" is quickly replaced with the table "B". During this period, the table "C" waits in the left handover area in a state in which the table "C" is engaged with the carrier 210C. As the table "A" supplies the ECs, it is eventually bought into a state in which even if the table "B" may be moved backward, the table "B" no longer goes into a one-table area of the EC-supply area that is adjacent to the left handover area. At this time, as shown in Fig. 12B, the table "C" is moved into the EC-supply area and waits there. After the table "A" finishes the supplying of ECs, the table "A" is moved to the right handover area, while the table "B" is moved by the carrier 210B to supply the ECs.

After the table "A" starts supplying the ECs, the right movable member 240 of the right table retracting device 212 waits at a position where the right movable member 240 extends over the right half area of the carrier-movement area, that is, the right handover area and a two-table area of the carrier-movement area that is adjacent to the right handover area. After the table "A" is moved to the right handover area, the engaging portion 262 of the retraction-associated engaging device 260A engages the table "A". Then, the carrier 210A is disengaged from the table "A" and, as shown in Fig. 12C, the right movable member 240 is moved rightward by a distance equal to the length of one table 202, and the table 202A is moved into the right waiting area. After the table "C" is brought into a state in which the table "C" follows the table "B", the left movable member 272 of the left table retracting device 214 is moved toward the carrier-movement area, so that the table "D" is moved to the left handover area. After the carrier 210A is disengaged from the table "A", the carrier 210A is moved backward to the left handover area and is engaged with the table "D", and the retraction-associated engaging device 260D is disengaged from the table "D".

Once the table "D" is brought into a state in which even if the table "C" may be moved backward, the table "C" no longer collides with the table "D", the table "D" is moved by the carrier 210A to the EC-supply area where the table "D" waits for the supplying of ECs. After the table "B" finishes the supplying of ECs, as shown in Fig. 12D, the table "B" is moved by the carrier 210B to the right handover area, and the engaging device 260B of the right table retracting device 212 is engaged with the table "B", and then the carrier 210B is disengaged from the table "B". At a terminal stage of an EC-supply period in which the table "C" supplies the ECs, the table "D" is moved to follow the table "C". After the table "C" finishes the supplying of ECs, the engaging device 260C of the right table retracting device 212 is engaged with the table "C", and then the carrier 210C is disengaged from the table "C". During this duration, the table "D" continues supplying the ECs, as shown in Fig. 12E.

After all the tables "A", "B", "C", "D" finishes the supply of ECs, the left table retracting device 214 is moved to the EC-supply area, and the engaging device 260D is engaged with the table "D". Then, the carrier 210A is disengaged from the table "D", and then the left movable member 272 is moved to the left waiting area and the right movable member 240 is moved to its left-end position where the right movable member 240 extends over the left handover area and the EC-supply area. Thus, the four tables "A", "B", "C", "D" are returned to their EC-supply start position shown in Fig. 11A, and are prepared for supplying ECs to the second PWB "II".

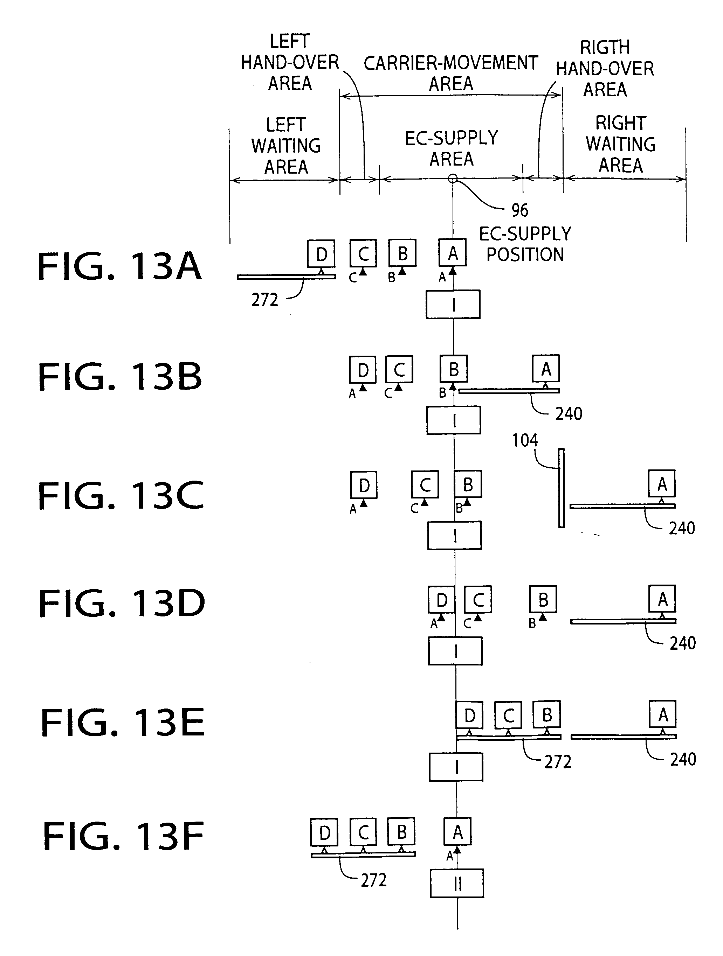

Next, there will be described, by reference to Figs. 13A-13F, 14A-14F, 15A-15F, and 16A-16F, a special case where while one of the four tables "A", "B", "C", "D" supplies ECs, at least one of the EC feeders 64 on the one table has supplied all the ECs and become unable to supply any ECs. However, no detailed description of the same steps as described above for the embodiment shown in Figs. 1 to 7, such as the replacement of the tables 202, and of the same steps as described above for the normal EC supplying operation, is provided. In Figs. 13A-13F, 14A-14F, 15A-15F, and 16A-16F, the same symbols as used in the Figs. 12A-12E are used to indicate the tables 202A-202D, the carriers 210A-210C, the respective engaging devices 260A-260F of the right and left table retracting devices 212, 214, and the PWBs 22.

Next, there will be described, by reference to Figs. 13A-13F, a first special case where one of the EC feeders 64 provided on the first table "A" has supplied all ECs stored therein and accordingly has become unable to supply any ECs. At the step shown in Fig. 13A, at which the table "A" supplies the ECs, if the tape-end detecting device 130 detects that one of the EC feeders 64 on the table "A" has supplied all ECs stored therein, the control device 280 defers the supplying of one or more ECs from the one EC feeder 64, and continues the supplying of ECs from the following EC feeders 64 on the table "A". After the table "A" finishes the supplying of ECs from all the EC feeders 64 except the one EC feeder 64 having no ECs, the table "A" is replaced with the table "B", and the table "A" is moved to the right handover area. As shown in Fig. 13B, in the right handover area, the engaging device 260A provided on the right movable member 240 is engaged with the table "A", and the carrier 210A is disengaged from the table "A". The table "A" is moved with the right movable member 240 to the right waiting area by the right retracting device 212, and the buzzer of the display device 154 informs the operator of the fact that the table "A" has the one EC feeder 64 having no ECs. In addition, the display device 154 displays, on the CRT thereof, identification information (e.g., identification number) indicating the one EC feeder 64 having no ECs.

When the operator opens the cover member 100, as shown in Fig. 13C, the shutter member 104 provided between the right waiting area and the carrier-movement area is closed, and the table "A" is inhibited from being moved out of the right waiting area. The operator performs his or her operation on the one EC feeder 64 having no ECs, e.g., replacing the one EC feeder 64 with a new one. When the operator finishes his or her operation and closes the cover member 100, the shutter member 104 is opened, as shown in Fig. 13D, and the table "A" is allowed to move out of the right waiting area. Concurrently, the tables "B", "C", and "D" sequentially supply ECs and, when those tables finishes the supplying of ECs, the table "B" is moved to the right handover area adjacent to the right waiting area, and the tables "C", "D" are moved to a two-table portion of the EC-supply area that is adjacent to the right handover area. Then, as shown in Fig. 13E, the left movable member 272 is moved to a position where the member 272 extends over the right handover area and the EC-supply area, the engaging devices 260D, 260E, 260F on the member 272 are engaged with the tables "B", "C", "D", respectively, and the carriers 210B, 210C, 210A are disengaged from the tables "B", "C", "D", respectively. Next, as shown in Fig. 13F, the left movable member 272 is moved to a position where the member 272 extends over the left waiting area, the left handover area, and a one-table portion of the EC-supply area that is adjacent to the left handover area. Thus, the tables "B", "C", "D" are returned to their EC-supply start positions. When the right movable member 240 and the table "A" are moved from the right waiting area toward the left waiting area, the table "A" is moved to the carrier-movement area (e.g., the right handover area), is engaged with one of the carriers 210A-210C (e.g., the carrier 210A, as shown in Fig. 13F), and is disengaged from the right movable member 240. Then, the table "A" is positioned again at the EC-supply position, so that the new EC feeder 64 which has replaced the one EC feeder 64 having no ECs, or the one EC feeder 64 which has been replenished with new ECs, supplies, for being mounted on the first PWB "I", the one or more ECs the supplying of which had been deferred. After the table "A" finishes the supplying of one or more ECs that had been deferred, the table "A" is kept at the EC-supply position, and the second PWB "II" is carried in to the EC-mount station. Then, the table "A" starts supplying ECs. The tables "B", "C" are engaged with the carriers 210B, 210C, respectively, and are disengaged from the engaging devices 260D, 260E, respectively. Then, the tables "B", "C" operate in the same manner as described above by reference to Figs. 12A-12E. As described above, the table "D" is engaged with the engaging device 260F that is different from the engaging device 260D with which the table "D" is engaged in the normal EC supplying operation, as shown in Figs. 12A and 12B. However, like in the normal EC supplying operation, after the table "C" has been brought into a state in which the table "C" follows the table "B" in the EC-supply area, the left movable member 272 is moved toward the carrier-movement area, and the table "D" is moved to the left handover area.

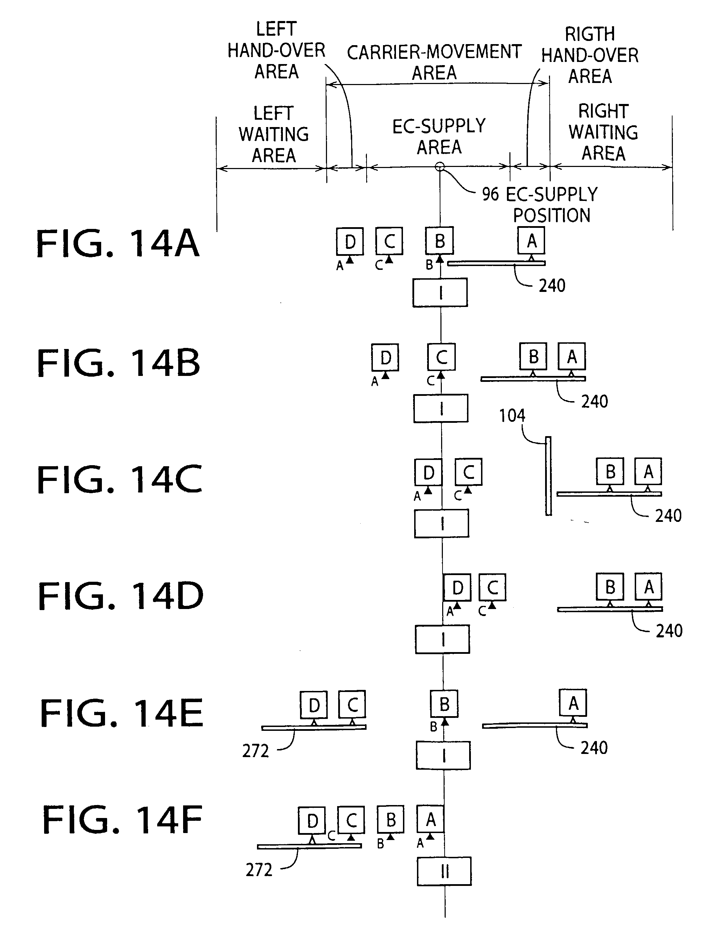

Next, there will be described, by reference to Figs. 14A-14F, a second special case where one of the EC feeders 64 provided on the second table "B" has supplied all FCs stored therein and accordingly has become unable to supply any ECs. At the step shown in Fig. 14A, at which the table "A" has finished the supplying of ECs, if the tape-end detecting device 130 detects that one of the EC feeders 64 on the table "B" has supplied all ECs stored therein, the control device 280 defers the supplying of one or more ECs from the one EC feeder 64, and continues the supplying of ECs from the following EC feeders 64 on the table "B". After the table "B" finishes the supplying of ECs, the table "B" is moved, as shown in Fig. 14B, to the right handover area, and the engaging device 260B provided on the right movable member 240 is engaged with the table "B". The engaging device 260A on the member 240 has already been engaged with the table "A" that has already finished the supplying of ECs. Then, the table "B" is moved with the table "A" to the right waiting area. As described above by reference to Fig. 13C, the operator opens the cover member 100, so that the shutter member 104 is closed, and the operator performs his or her operation such as replacing the one EC feeder 64 having no ECs, with a new one. During this duration, the tables "C", "D" continue supplying ECs. After the operator finishes his or her operation in the right waiting area, the cover member 100 is closed so that, as shown in Fig. 14D, the shutter member 104 is opened and the tables "A", "B" are allowed to move out of the right waiting area.

After the tables "C", "D" finishes the supplying of ECs, those tables are moved to the two-table portion of the EC-supply area that is adjacent to the right handover area, and the engaging devices 260D, 260E on the left movable member 272 are engaged with the tables "C", "D", respectively. As shown in Fig. 14E, the left movable member 272 is moved to a position where the member 272 extends over the left handover area and the left waiting area. Thus, the tables "C", "D" are returned to their EC-supply start positions. When the right movable member 240 is moved from the right waiting area toward the left waiting area, the table "B" is moved to the EC-supply area (e.g., the right handover area), one of the carriers 210A-210C (e.g., the carrier 210B, as shown in Fig. 14E) is engaged with the table "B", and the engaging device 260B is disengaged from the table "B". Then, the table "B" is positioned at the EC-supply position, so that the new EC feeder 64 which has replaced the one EC feeder 64 having no ECs, or the one EC feeder 64 which has been replenished with new ECs, supplies, for being mounted on the first PWB "I", the one or more ECs the supplying of which had been deferred. At this time, the table "A" remains engaged with the engaging device 260A, at a position where the table "A" does not interfere with the table "B". After the table "B" finishes the supplying of one or more ECs that had been deferred, the table "B" is moved again to the right handover area where the right movable member 240 waits, is engaged with the engaging device 260B, and is disengaged from the carrier 210B. Alternatively, it is possible to move the right movable member 240 to a position where the table "B" has just finished the supplying of ECs, so that there the engaging device 260B on the member 240 is engaged with the table "B".

After, as shown in Fig. 14F, the tables "A", "B" are moved to the EC-supply start positions and are engaged with the carriers 210A, 210B, the tables "A", "B" are disengaged from the engaging devices 260A, 260B on the right movable member 240. Thus, the tables "A", "B" are prepared for supplying ECs for being mounted on the second PWB "II". Meanwhile, the table "C" which had been moved to its EC-supply start position, has been engaged with the carrier 210C and has been disengaged from the engaging device 260D. The table "D" has been kept engaged with the engaging device 260E in the left waiting area, and waits for supplying ECs.

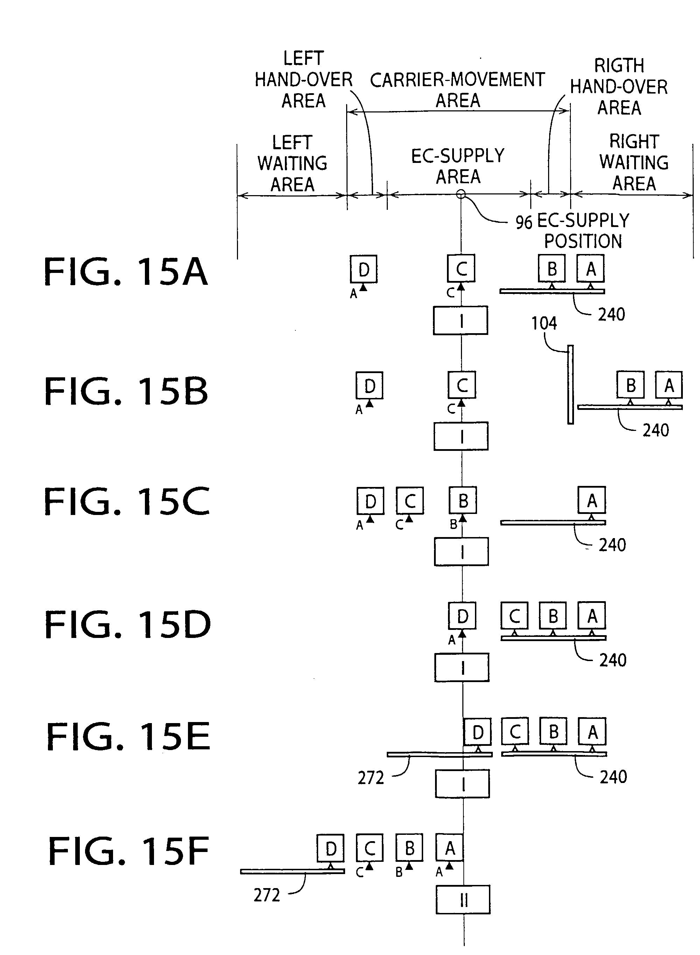

Next, there will be described, by reference to Figs. 15A-15F, the second special case where one of the EC feeders 64 provided on the second table "B" has supplied all ECs stored therein and accordingly has become unable to supply any ECs. In the control method described above by reference to Figs. 14A-14F the table "B" performs the deferred supplying of one or more ECs from the one EC feeder 64, after all the tables "C", "D" that are subsequent to the table "B" finishes the supplying of ECs. In contrast, in the control method described below by reference to Figs. 15A-15F, the table "B" performs the deferred supplying of one or more ECs from the one EC feeder 64, after only the table "C" that is next to the table "B" finishes the supplying of ECs.

As shown in Figs. 15A and 15B, the table "B" is moved, after finishing the supplying of ECs, together with the table "A" to the right waiting area, in the same manner as described above by reference to Figs. 14A-14F. When the operator finishes his or her operation on the table "B", such as replacing EC feeders 64, and closes the cover member 100, the shutter member 104 is opened, and the tables "A", "B" are allowed to move out of the right waiting area. During this duration, the table "C" continues supplying ECs. In the present control method, at a terminal stage of an EC-supply period in which the table "C" supplies the ECs, the table "D" is not moved to follow the table "C", and is kept still in the left handover area. After the table "C" finishes the supplying of ECs, the table "C" is moved, as shown in Fig. 15, to the one-table portion of the EC-supply area that is adjacent to the left handover area, so that the table "B" is allowed to move to the EC-supply area. In addition, the right movable member 240 is moved toward the left handover area, so that the table "B" is moved to the carrier-movement area (e.g., the right handover area) and is engaged with the carrier 210B. Then, the table "B" is positioned at the EC-supply position, and performs the deferred supplying of one or more ECs from the one EC feeder 64. After the table "B" finishes the deferred supplying of one or more ECs, the table "B" is moved by the carrier 210B toward the right waiting area, and is engaged again with the engaging device 260B. Since the table "C" had finished the supplying of ECs, the table "C" is also moved, as shown in Fig. 15D, to the right movable member 240 and is engaged with the engaging device 260C. The table "D" supplies, at the EC-supply position, the ECs for being mounted on the first PWB "I". In the present control method, the control device 280 controls the tables "B", "C", such that after the table "C" finishes the supplying of ECs, the table "B" performs the deferred supplying of one or more ECs. However, it is possible that even if the table "C" may be supplying ECs, i.e., may not have finished the supplying of ECs, the table "C" be replaced with the table "B", so long as the operator has already finished his or her operation on the table "B", such as the replacement of EC feeders 64. In the latter case, after the table "B" finishes the deferred supplying of one or more ECs, the table "B" is replaced with the table "C", so that the table "C" supplies the ECs from the remaining EC feeders 64 thereon.

After the table "D" finishes the supplying of ECs, the left movable member 272 is moved, as shown in Fig. 15E, to the EC-supply area, so that the engaging device 260D is engaged with the table "D" and the table "D" is returned to its EC-supply start position. In addition, the right movable member 240 is moved toward the left waiting area, so that the tables "A", "B", "C" are returned to their EC-supply start positions. Then, the tables "A", "B", "C" are engaged with the carriers 210A, 210B, 210C, respectively, the second PWB "II" is carried in and is positioned at the EC-mount station, and the table "A" starts supplying ECs for being mounted on the second PWB "II".

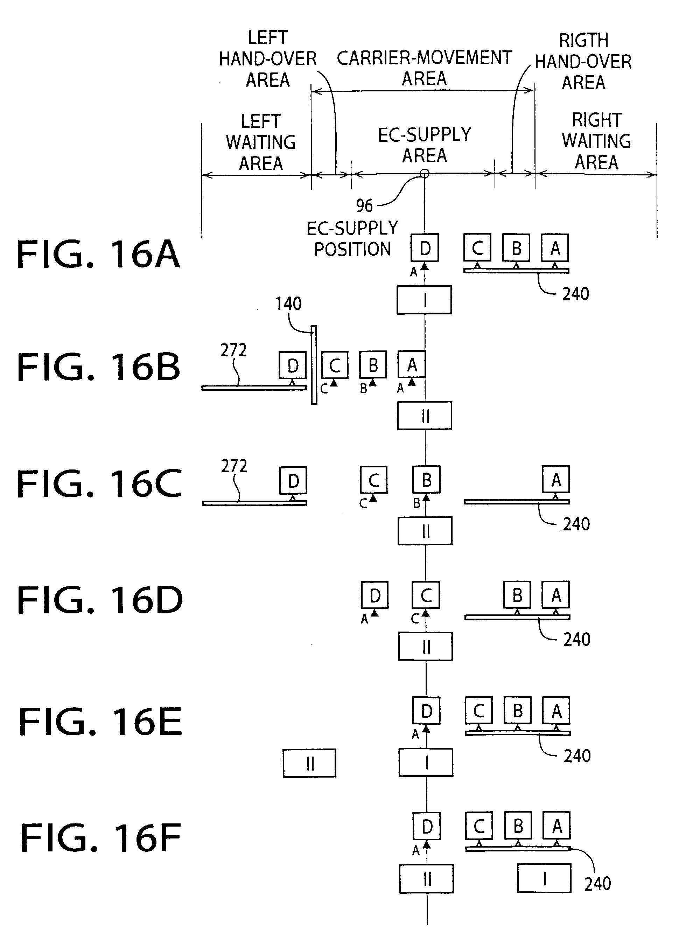

Next, there will be described, by reference to Figs. 16A-16F, a third special case where one of the EC feeders 64 provided on the fourth table "D" has supplied all ECs stored therein and accordingly has become unable to supply any ECs. As shown in Fig. 16A, the tables "A", "B", "C" sequentially supply ECs and, after those tables finish the supplying of ECs, those tables are engaged with the engaging devices 260A, 260B, 260C on the right movable member 240, respectively. If the table "C" is replaced with the table "D" and the tape-end detecting device 130 detects that while the table "D" supplies the ECs, one of the EC feeders 64 provided on the fourth table "D" has supplied all ECs stored therein, the control device 280 defers the supplying of one or more ECs from the one EC feeder 64 and continues supplying the ECs from the remaining EC feeders 64. After the table "D" finishes the supplying of ECs from all the EC feeders 64 except the one EC feeder 64 having no ECs, the left movable member 272 is moved so that the engaging device 260D on the member 272 is engaged with the table "D". Then, as shown in Fig. 16B, the table "D" is moved to the left waiting area, and the buzzer of the display device 154 informs the operator of the fact that the table "D" has the one EC feeder 64 having no ECs. When the operator opens the cover member 100, the shutter member 104 provided between the left waiting area and the carrier-movement area is automatically closed, and the table "D" is inhibited from moving into the EC-supply area. In the left waiting area, the operator performs his or her operation, e.g., replacing the one EC feeder 64 with a new one. In addition, the right movable member 240 is moved to a position where the member 240 extends over the left handover area and the EC-supply area, so that the tables "A", "B", "C" are returned to their EC-supply start position. After the tables "A", "B", "C" are engaged with the carriers 210A, 210B, 210C, respectively, those tables are disengaged from the engaging devices 260A, 260B, 260C on the right movable member 240, respectively. The second PWB "II" is carried in and is positioned at the EC-mount station, and the table "A" is positioned at the EC-supply position to start supplying ECs for being mounted on the second PWB "II". One or more tables which has or have finished the supplying of ECs is or are, as described above by reference to Fig. 16A, engaged with the right movable member 240 and is moved to a position where the table or tables does or do not interfere with the table which is supplying the ECs in the EC-supply area.

After the operator finishes his or her operation on the table "D", such as the replacement of EC feeders 64, he or she closes the cover member 100, so that as shown in Figs. 16C and 16D, the shutter member 104 is automatically opened and the table "D" is allowed to move into the EC-supply area. During this duration, the tables "A", "B", "C" sequentially supply ECs. After the table "C" finishes the supplying of ECs, the table "C" is replaced with the table "D". At this time, as shown in Fig. 16D, the incomplete, second PWB "II" is returned from the EC-mount station to the upstream side thereof, and the incomplete, first PWB "I" is returned to the EC-mount station from the downstream side thereof, so that the table "D" performs, for the first PWB "I", the deferred supplying of one or more ECs from the one EC feeder 64, and thereby completes the first PWB "I" into an electric-circuit board. Subsequently, as shown in Fig. 16F, in the state in which the table "D" is kept at the EC-supply position, the second PWB "II" is carried in to the EC-mount station, so that the table "D" supplies ECs for being mounted on the second PWB "II". However, this control method may be modified such that in the state in which the second PWB "II" is kept at the EC-mount station, first the table "D" supplies ECs for being mounted on the second PWB "II" to complete the same "II", subsequently the complete, second PWB "II" is returned from the EC-mount station to the upstream side thereof, the imcomplete, first PWB "I" is returned to the EC-mount station from the downstream side thereof, and the table "D" performs the deferred supplying of one or more ECs for being mounted on the first PWB "1" to complete the same "I".

In the second embodiment, even if at least one of the EC feeders 64 on one of the three or more EC-supply tables 202 may become unable to supply any ECs, the current EC supplying operation can be continued without being interrupted, like in the first embodiment in which the two EC-supply tables 68, 70 are employed. This leads to improving the rate of operation of the present EC mounting system.

In each of the illustrated embodiments, the control device 110, 280 defers the supplying of one or more ECs from one or more EC feeders 64 which have been detected as having no ECs stored therein. However, if there are one or more subsequent EC feeders 64 which are subsequent to one EC feeder 64 having no ECs and have an essential need to supply ECs subsequent to the one EC feeder 64 having no ECs, the control device 110, 280 as the table-moving-device control device may control the table moving device to defer not only the supplying of one or more ECs from one or more EC feeders 64 having no ECs, but also the supplying of one or more ECs from the one or more subsequent EC feeders 64.

In addition, in each of the illustrated embodiments, a detecting device which detects a disorder or a jamming of each EC feeder 64 may be employed. In this case, the control device 110, 280 may control the table moving device to defer not only the supplying of one or more ECs from one or more EC feeders 64 having no ECs, but also the supplying of one or more ECs from one or more EC feeders 64 on which a disorder or a jamming has been detected by the detecting device.

The index servomotor 34 may be replaced with a stepper motor. In addition, in the embodiment shown in Figs. 1 to 7, the EC-supply tables 68, 70 are moved by the servomotors 88, 90 as the drive sources, and are stopped at respective arbitrary positions based on the respective outputs of the encoders 92, 94; and in the embodiment shown in Figs. 8 to 16, the movable members 240, 272 of the right and left table retracting devices 212, 214 are moved by the servomotors 248, 276 as the drive sources, and are stopped at respective arbitrary positions based on the respective output signals of the encoders 250, 278. However, those servomotors 88, 90, 248, 276 may be replaced with common electric motors different than servomotors. In the latter case, the tables 68, 70 and the members 240, 272 may be provided with respective detectable portions, and sensors may be provided at the predetermined stop positions where the tables 68, 70 and the members 240, 272 should be stopped. The tables 68, 70 and the members 240, 272 are stopped at the stop positions based on the output signals of the sensors which detect the detectable portions of the tables and members 68, 70, 240, 272.

The operation device 132 may be provided with an input device as a manually operable member which is manually operable by an operator for inputting an information that the operator has finished his or her operation, such as the replacement of EC feeders, in the right or left waiting area. In this case, when the operator operates this input device to input the information, the table-movement inhibiting device allows each of the EC-supply tables 68, 70 or each of the EC-supply tables 202A-202D to be moved out of the right or left waiting area.

In each of the illustrated embodiments, the right or left shutter member 104 is automatically opened and closed in response to the closing and opening of the cover member 100, respectively. However, it is possible to control the cover member 100 and each shutter member 104, independent of each other.

In each of the illustrated embodiments, the tables 60, 62 and the carriers 210A-210C have the respective nuts (not shown) which are fixed thereto and which are threadedly engaged with the respective feed screws 84, 86, 222 which are provided on the bed 79 such that the feed screws are rotatable relative to the bed 79, and, when the feed screws are rotated, the tables 60, 62 and the carriers 210A-210C are moved. However, it is possible that respective nuts be rotatably provided on the tables 60, 62 and the carriers 210A-210C and respective electric motors be provided on the same 60, 62, 210A-210C to rotate the respective nuts, and that respective feed screws be fixed to the bed 79. In the latter case, when the nuts are rotated by the electric motors, the tables 60, 62 and the carriers 210A-210C are moved. Otherwise, it is possible that the tables 60, 62 and the carriers 210A-210C be provided by respective movable portions of linear motors. The respective carrier-associated engaging devices 234 of the three carriers 210A-210C may be replaced with respective engaging devices provided on the four tables 202A-202D. The number of the engaging devices 234 needed in the former case is smaller than that of the engaging devices needed in the latter case.

In each of the illustrated embodiments, the EC supplying apparatus 20 may employ other sorts of EC feeders than the EC feeders 64 each of which feeds an EC tape carrying a plurality of ECs at a predetermined, regular interval, and thereby feeds each EC to the EC-supply portion thereof. For example, the EC supplying apparatus 20 may employ EC feeders each of which stores a number of ECs in bulk in a casing, makes the ECs into an array of ECs by utilizing vibration, inclination, air flow, or a belt, and feeds the array of ECs to an EC-supply portion thereof.

The present invention is applicable to an EC supplying apparatus which supplies ECs to an EC mounting device which includes at least one EC holding head and a holding-head moving device and which controls the moving device to move the EC holding head in one direction or two orthogonal directions on a horizontal plane and thereby mount ECs on a printed-wiring board. In addition, the present invention is applicable to not only an EC supplying apparatus which supplies ECs to an EC mounting device but also an EC supplying apparatus which supplies ECs to an EC transferring apparatus which transfers ECs.

Each feature disclosed in this specification (which term includes the claims) and/or shown in the drawings may be incorporated in the invention independently of other disclosed and/or illustrated features.

Statements in this specification of the "objects of the invention" relate to preferred embodiments of the invention, but not necessarily to all embodiments of the invention falling within the claims.

The description of the invention with reference to the drawings is by way of example only.

The text of the abstract filed herewith is repeated here as part of the specification.

A method of supplying electric components from component-supply tables each of which includes component feeders whose respective component-supply portions are arranged along a line and each of which stores electric components of one sort and supplies the components, one by one, from the component-supply portion thereof, the method including the steps of moving a first one of the tables along the line in a component-supply area so as to position each of the respective component-supply portions of the feeders of the first table, at a component-supply position, keeping a second one of the tables still in one of two waiting areas provided on both sides of the component-supply area, placing, when one of the feeders of the second table kept still in the one waiting area is unable to supply any electric components, the one feeder in a state in which the one feeder is able to supply electric components, moving, at a terminal stage of a component-supply period in which the first table supplies the components, a third one of the tables is to supply electric components after the first table, such that the third table is moved near, and with, the first table, and replacing, with the third table, the first table which includes one feeder unable to supply any electric components, so that the third table supplies the components in place of the first table, while deferring the supplying of electric component from at least the one feeder of the first table.

## Claims

1. A method of supplying electric components from a plurality of component-supply bodies each of which includes a movable body and a plurality of component feeders for storing electric components, the method comprising the steps of:
moving a first supply component-supply body in a component-supply area so as to position component feeders of the component-supply body at component-supply positions for supply of at least one electric component from said feeders;
holding a second component-supply body in a waiting area to enable a component feeder of said second component-supply body to be serviced (as defined);
moving a replacement component-supply body into the component-supply area during supply of components from the first component-supply body; and
replacing the first component-supply body in the component-supply area with the replacement component supply body when at least one of the component feeders of the first component-supply body is unable to supply any electric components so as to continue to supply electric components from the component-supply area without interruption.

2. A method according to Claim 1, wherein the step of moving the first component-supply body in the component-supply area comprises finding, from the component feeders of the first component-supply body, said at least one component feeder which is unable to supply any electric components, and deferring the supplying of at least one electric component from at least said one component feeder of the first component-supply body, wherein the step of replacing the first component-supply body comprises replacing the first component-supply body with the replacement component-supply body, moving the first component-supply body from the component-supply area into a waiting area, holding the first component-supply body in said waiting area, and placing said one component feeder of the first component-supply body in a state in which said at least one component feeder is able to supply electric components, and wherein the method further comprises a step of moving the first component-supply body into the component-supply area so as to perform the deferred supplying of at least one electric component from said at least one component feeder of the first component-supply body.

3. A method according to Claim 2, wherein the second component-supply body is the replacement component-supply body, wherein the step of moving the first component-supply body in the component-supply area comprises moving the first component-supply body to supply the electric components for mounting on a printed-wiring board, and determining, from the component feeders of the first component-supply body, said at least one component feeder which is unable to supply any electric components, and deferring the supply of at least one electric component from said at least one component feeder of the first component-supply body, wherein the step of replacing the first component-supply body comprises replacing the first component-supply body with the second component-supply body, moving, while the second component-supply body supplies, the electric components from the component-supply area for mounting on the printed-wiring board, the first component-supply body from the component-supply area into a waiting area, holding the first component supply body in said waiting area, and placing said at least one component feeder of the first component-supply body in said state in which said at least one component feeder is able to supply electric components, and wherein the step of moving the first component-supply body into the component-supply area comprises moving, after the second component-supply body finishes supplying the electric components, the first component-supply body into the component-supply area to replace the second component-supply body with the first component-supply body and perform the deferred supply of at least one electric component from said at least one component feeder of the first component-supply body.

4. A method according to Claim 2, wherein the second component-supply body is the replacement component-supply body, wherein the step of moving the first component-supply body in the component-supply area comprises moving the first component-supply body to supply the electric components for mounting on a first printed-wiring board, and determining from the component feeders of the first component-supply body, at least one component feeder which is unable to supply any electric components, and deferring the supply of at least one electric component from said at least one component feeder of the first component-supply body, wherein the step of replacing the first component-supply body comprises replacing the first component-supply body with the second component-supply body, conveying the incomplete first printed-wiring board from a component-mount station, conveying a second printed-wiring board to the component-mount station, moving, while the second component-supply body supplies the electric components from the component-supply area to the second printed-wiring board, the first component-supply body from the component-supply area into a waiting area, holding the first component-supply body in said one waiting area, and placing said at least one component feeder of the first component-supply body in said state in which said one component feeder is able to supply electric components, and wherein the step of moving the first component-supply body into the component-supply area comprises moving, after the second component-supply body finishes supplying the electric components for mounting on the second printed-wiring board, the first component-supply body into the component-supply area so as to replace the second component-supply body with the first component-supply body, moving the second printed-wiring board from the component-mount station, moving the first printed-wiring board to the component-mount station and performing from the first printed-wiring board, the deferred supplying of at least one electric component from said at least one component feeder of the first component-supply body.

5. A method according to Claim 2, wherein the replacement component-supply body is different from the second component-supply body, wherein the step of moving the first component-supply body in the component-supply area comprises moving the first component-supply body to supply electric components mounted on a printed-wiring board, and determining, from the component feeders of the first component-supply body, at least one component feeder which is unable to supply any electric components, and deferring the supply of at least one electric component from said at least one component feeder of the first component-supply body, wherein the step of replacing the first component-supply body comprises replacing the first component-supply body with the replacement component-supply body, moving, while at least the replacement component-supply body supplies the electric components for mounting on the printed-wiring board from the component-supply area, the first component-supply body from the component-supply area into a waiting area, holding the first component-supply body in said waiting area, and placing said at least one component feeder of the first component-supply body in said state in which said at least one component feeder is able to supply electric components, and wherein the step of moving the first component-supply body into the component-supply area comprises moving, after at least the replacement component-supply body finishes supplying the electric components, the first component-supply body toward another waiting area via the component-supply area where the first component-supply body performs the deferred supplying of at least one electric component from said at least one component feeder of the first component-supply body.

6. A method according to Claim 2, wherein the replacement component-supply body is different from the second component-supply body, wherein the step of moving the first component-supply body in the component-supply area comprises moving the first component-supply body to supply the electric components for mounting on a printed-wiring board and determining, from the component feeders of the first component-supply body, at least one component feeder which is unable to supply any electric components, and deferring the supplying of at least one electric component from said at least one component feeder of the first component-supply body, wherein the step of replacing the first component-supply body comprises replacing the first component-supply body with the replacement component-supply body, moving, while the replacement component-supply body supplies the electric components from the component-supply area, the first component-supply body from the component-supply area into a waiting area, holding the first component-supply body in said waiting area, and placing said at least one component feeder of the first component-supply body in said state in which said at least one component feeder is able to supply electric components, and wherein the step of moving the first component-supply body into the component-supply area comprises moving, after the replacement component-supply body finishes supplying the electric components, the first component-supply body into the component-supply area so as to perform, for the printed-wiring board, the deferred supplying of at least one electric component from said at least one component feeder of the first component-supply body.

7. A method according to any one of Claims 2 to 6, wherein the step of deferring the supply of at least one electric component from said at least one component feeder of the first component-supply body comprises deferring the supply of at least one electric component from only said at least one component feeder of the first component-supply body.

8. A method according to any one of Claims 2 to 6, wherein the step of deferring the supply of at least one electric component from at least said one component feeder of the first component-supply body comprises deferring the supply of at least one electric component from said at least one component feeder of the first component-supply body and at least one other component feeder of the first component-supply body that is to supply at least one electric component subsequent to said at least one component feeder.

9. A method according to Claim 8, wherein the step of deferring the supply of at least one electric component from said at least one other component feeder of the first component-supply body comprises deferring, when a plurality of subsequent component feeders of the first component-supply bodies which are to supply at least one electric component subsequent to said at least one component feeder of the first body comprise at least one particular subsequent component feeder which is required to supply at least one electric component subsequent to said at least one component feeder of the first body, the supply of at least one electric component from the particular subsequent component feeder.

10. Apparatus (20) for supplying electric components to an electric-component mounting device (12) for mounting the electric components on a printed-wiring board (22) positioned at a component-mount station, the apparatus comprising:
a plurality of component-supply bodies (68, 70; 202A-202D) each of which includes a movable body (60, 62) and a plurality of component feeders (64) for storing electric components;
a body moving device (88, 90; 200,210A-210C, 220, 212, 214) for moving each of the component-supply bodies in a component-supply area and a waiting area; and
a body-moving-device control device (110; 280) for controlling the body moving device to move a first, supply component-supply bodies in the component-supply area so as to position component feeders of the component-supply body at component-supply positions for supply of at least one electric component from said feeders, for holding a second component-supply body in a waiting area, for moving a replacement component-supply body into said component-supply area during supply of components from said first component-supply body, and for replacing the first component-supply body in the component-supply area with a replacement component-supply body when at least one of the component feeders of the first component-supply body is unable to supply any electric components so as to continue to supply electric components from the component-supply area without interruption.

11. Apparatus according to Claim 10, further comprising a body-movement inhibiting device, (100, 102, 110) comprising a manually operable member (100) for inhibiting, based on a first manual operation of the manually operable member, the body moving device from moving the second component-supply body from said waiting area into the component-supply area and allowing, based on a second manual operation of the manually operable member, the body moving device to move the second component-supply body from said waiting area into the component-supply area.

12. Apparatus according to Claim 10 or Claim 11, further comprising:
a board conveying device (14, 16, 18) for conveying a printed-wiring board towards and away from a component-mount station; and
means (110) for controlling the board conveying device to convey a first-printed wiring board from the component-mount station, convey a second printed-wiring board to the component-mount station, and then move the second printed-wiring board from the component-mount station, and return the first printed-wiring board to the component-mount station.

13. Apparatus according to any one of Claims 10 to 12, further comprising:
means (130) for detecting, from the component feeders of the first component-supply body which is supplying electric components in the component-supply area, said at least one component feeder which is unable to supply any electric components, the body moving device control device being arranged to control the body moving device to move the first component-supply body in the component-supply area while deferring the supply of at least one electric component from said at least one component feeder of the first component-supply body and to move the first component-supply body including said one component feeder into a waiting area; and
means (154) for informing an operator that the first component-supply body has been moved into said waiting area.
